# EUROPEAN PATENT APPLICATION

(11) **EP 4 672 944 A1**
(43) Date of publication of application: **31.12.2025**
(21) Application number: 25173999.1
(22) Date of filing: 02.05.2025
(51) Int. Cl.: H10K 59/80, G02B 5/30, H10K 71/60

(54) **DISPLAY DEVICE AND METHOD OF MANUFACTURING THE SAME**

(30) Priority: 27.06.2024 KR 20240084440
(71) Applicant: Samsung Display Co., Ltd., Yongin-si, Gyeonggi-do 17113 (KR)
(72) Inventor: Jin, Dong Gyu, Yongin-si, Gyeonggi-do (KR); Cho, Hyun Min, Yongin-si, Gyeonggi-do (KR); Lee, Dong Min, Yongin-si, Gyeonggi-do (KR); Jung, Da Woon, Yongin-si, Gyeonggi-do (KR); Jeong, Jae Woo, Yongin-si, Gyeonggi-do (KR)
(74) Representative: Gulde & Partner

(57) **Abstract**

A display device and a method of manufacturing the same are provided. The display device comprises a substrate, a display element layer disposed on the substrate, and comprising a first electrode, a light-emitting layer, and a second electrode, a phase retardation layer disposed on the display element layer, and a wire grid polarizer disposed on the phase retardation layer, and comprising a wire grid pattern in which an insulating pattern and a grid pattern are stacked, wherein the insulating pattern and the grid pattern contain doped ions.

## Description

### BACKGROUND

### 1. TECHNICAL FIELD

The present disclosure relates to a display device and a method of manufacturing the same.

### 2. DESCRIPTION OF THE RELATED ART

A head mounted display (HMD) is an image display device that is worn on a user's head in the form of glasses or helmets to form a focus at a close distance in front of the user's eyes. The head mounted display may implement virtual reality (VR) or augmented reality (AR).

The head mounted display magnifies an image displayed on a small display device by using a plurality of lenses, and displays the magnified image. Therefore, the display device applied to the head mounted display needs to provide high-resolution images, for example, images with a resolution of 3000 PPI (Pixels Per Inch) or higher. To this end, an organic light-emitting diode on silicon (OLEDoS), which is a high-resolution small organic light-emitting display device, is used as the display device applied to the head mounted display. The OLEDoS is an image display device in which an organic light-emitting diode (OLED) is disposed on a semiconductor wafer substrate on which a complementary metal oxide semiconductor (CMOS) is disposed.

### SUMMARY

Aspects of the present disclosure provide a display device capable of providing a high-quality wire grid polarizer, and also provide a method of manufacturing the same.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the present disclosure, a display device comprises a substrate, a display element layer disposed on the substrate, and comprising a first electrode, a light-emitting layer, and a second electrode, a phase retardation layer disposed on the display element layer, and a wire grid polarizer disposed on the phase retardation layer, and comprising a wire grid pattern in which an insulating pattern and a grid pattern are stacked. The insulating pattern and the grid pattern contain doped ions.

In an embodiment, the doped ions contain boron.

In an embodiment, a concentration of the ions contained in the insulating pattern is different from a concentration of the ions contained in the grid pattern.

In an embodiment, a concentration of the ions contained in the insulating pattern is greater than a concentration of the ions contained in the grid pattern.

In an embodiment, a concentration of the ions contained in the insulating pattern gradually increases from a top surface to a bottom surface of the insulating pattern.

In an embodiment, a concentration of the ions contained in the grid pattern gradually increases from a top surface to a bottom surface of the grid pattern.

In an embodiment, a concentration of the ions contained in the insulating pattern is equal to a concentration of the ions contained in the grid pattern.

In an embodiment, the insulating pattern is disposed on the grid pattern, and a thickness of the insulating pattern is less than a thickness of the grid pattern.

In an embodiment, a width of the insulating pattern is equal to a width of the grid pattern.

In an embodiment, the display device further comprises a planarization layer disposed on the wire grid polarizer, and a capping layer disposed under the wire grid polarizer. The wire grid polarizer comprises an air layer disposed in an area defined by the capping layer, the wire grid pattern, and the planarization layer.

According to an aspect of the present disclosure, a display device comprises a substrate comprising a display area and a non-display area, a display element layer disposed on the display area, and comprising a first electrode, a light-emitting layer, and a second electrode, an encapsulation layer disposed on the display element layer, and disposed in the display area and the non-display area of the substrate, a phase retardation layer disposed on the encapsulation layer, and a wire grid polarizer disposed on the phase retardation layer. In the encapsulation layer, a first region overlapping the display area does not contain ions, and a second region overlapping the non-display area contains the ions.

In an embodiment, the wire grid polarizer comprises a wire grid pattern in which an insulating pattern and a grid pattern are stacked, and the insulating pattern and the grid pattern contain the ions.

In an embodiment, the ions contain boron.

In an embodiment, a concentration of the ions contained in the insulating pattern is different from a concentration of the ions contained in the grid pattern.

In an embodiment, a concentration of the ions contained in the insulating pattern is greater than a concentration of the ions contained in the grid pattern.

In an embodiment, a concentration of the ions contained in the insulating pattern is equal to a concentration of the ions contained in the grid pattern.

According to an aspect of the present disclosure, a method of manufacturing a display device, comprises preparing a target substrate provided with at least a display element layer, sequentially forming a metal material layer, an insulating material layer, and a resin layer on the target substrate, forming a resin pattern on the resin layer using a mold, performing a first etching on the resin layer to form a resin mask pattern, performing an ion doping process on the target substrate, performing a second etching on the insulating material layer to form a hard mask pattern, and performing a third etching on the metal material layer to form a grid pattern.

In an embodiment, the ion contains boron, and a dose of the boron ranges from 5E15/cm² to 1E16/cm².

In an embodiment, the ion doping process is performed with an acceleration voltage of 10 KeV to 20 KeV.

In an embodiment, by the third etching, the hard mask pattern is formed as an insulating pattern disposed on the grid pattern to form a wire grid polarizer on the target substrate.

According to an aspect of the present disclosure, a display device obtained by the above-mentioned method is provided. The display device may have the features as mentioned above.

The display device obtained by the above-mentioned method may provide a wire grid polarizer having a grid pattern formed continuously without interruption and having a relatively uniform width. Thus, the display device according to the present invention shows distinct differences in comparison to the conventional display device.

In the display device and the method of manufacturing the same according to an embodiment, by doping ions into a resin mask pattern to make the resin mask pattern robust to an etching process, the resin mask pattern may be enabled to perform the role of a mask well, and a process margin may be secured due to enhanced etching selectivity. Accordingly, by forming a grid pattern of the wire grid polarizer to have uniform pitch and width, the transmittance and the polarization degree of the wire grid polarizer may be improved.

However, effects according to the embodiments of the present disclosure are not limited to those exemplified above and various other effects are incorporated herein.

### BRIEF DESCRIPTION OF THE DRAWINGS

The above and other aspects and features of the present disclosure will become more apparent by describing in detail embodiments thereof with reference to the attached drawings.
FIG. 1 is an exploded perspective view showing a display device according to an embodiment.
FIG. 2 is a block diagram illustrating a display device according to an embodiment.
FIG. 3 is an equivalent circuit diagram of a first pixel according to an embodiment.
FIG. 4 is a layout diagram illustrating an example of a display panel according to an embodiment.
FIG. 5 is a layout diagram showing embodiments of the display area of FIG. 4.
FIG. 6 is a cross-sectional view illustrating an example of a display panel 100 taken along line X-X' of FIG. 5.
FIG. 7 is an enlarged view of area A of FIG. 6.
FIG. 8 is a plan view schematically illustrating a display device according to an embodiment.
FIGS. 9, 10, 11, 12, 13, 14, 15, 16, 17, and 18 are diagrams showing a method of manufacturing a display device according to an embodiment.
FIG. 19 is a planar image of a wire grid polarizer manufactured according to a comparative example.
FIG. 20 is a planar image of a wire grid polarizer according to an embodiment.
FIG. 21 is a perspective view illustrating a head mounted display according to an embodiment.
FIG. 22 is an exploded perspective view illustrating an example of the head mounted display of FIG. 21.
FIG. 23 is a perspective view illustrating a head mounted display according to an embodiment.

### DETAILED DESCRIPTION OF THE EMBODIMENTS

The present inventive concept will now be described more fully hereinafter with reference to the accompanying drawings, in which embodiments of the inventive concept are shown. The inventive concept may, however, be embodied in different forms and should not be construed as limited to the embodiments set forth herein. Rather, these embodiments are provided so that this disclosure will be thorough and complete, and will fully convey the scope of the inventive concept to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the inventive concept. Similarly, the second element could also be termed the first element.

Each of the features of the various embodiments of the present disclosure may be combined or combined with each other, in part or in whole, and technically various interlocking and driving are possible. Each embodiment may be implemented independently of each other or may be implemented together in an association.

Hereinafter, embodiments will be described with reference to the accompanying drawings.

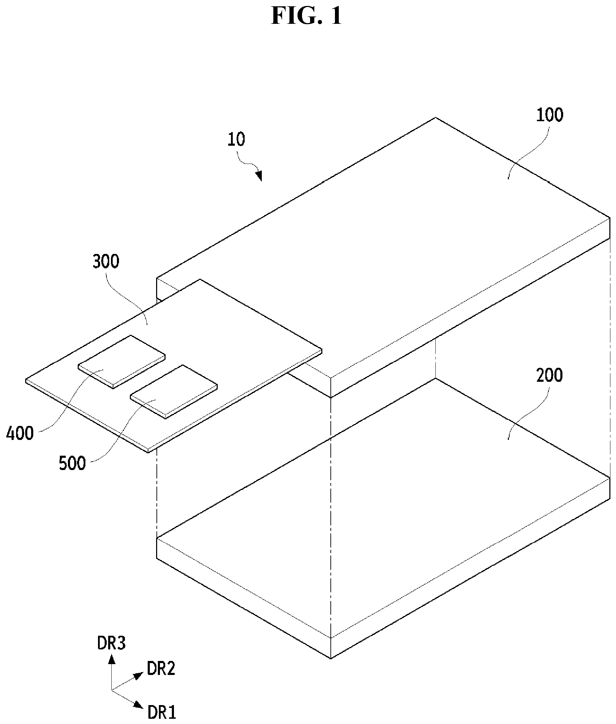

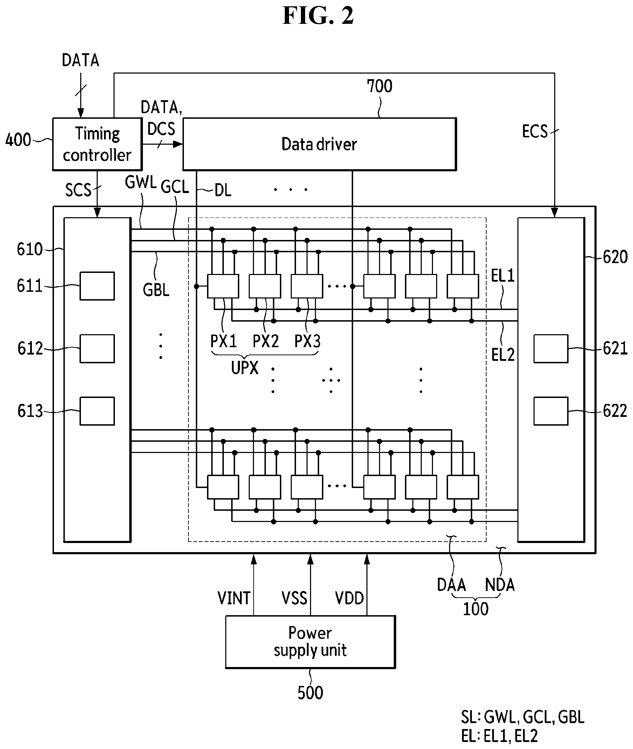

FIG. 1 is an exploded perspective view showing a display device 10 according to an embodiment. FIG. 2 is a block diagram illustrating the display device 10 according to an embodiment.

Referring to FIGS. 1 and 2, the display device 10 according to an embodiment is a device displaying a moving image or a still image. The display device 10 according to an embodiment may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC) or the like. For example, the display device 10 according to an embodiment may be applied as a display unit of a television, a laptop, a monitor, a billboard, or an Internet-of-Things (IoT) terminal. In an embodiment, the display device 10 may be applied to a smart watch, a watch phone, a head mounted display (HMD) for implementing virtual reality and augmented reality, and the like.

The display device 10 according to an embodiment may include a display panel 100, a heat dissipation layer 200, a circuit board 300, a timing control circuit 400, sometimes called a timing controller 400, and a power supply circuit 500, sometimes called a power supply unit 500.

The display panel 100 may have a planar shape similar to a quadrilateral shape. For example, the display panel 100 may have a planar shape similar to a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a predetermined curvature. The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the present disclosure is not limited thereto.

The display panel 100 may include a display area DAA displaying an image and a non-display area NDA not displaying an image as shown in FIG. 2.

The display area DAA may include a plurality of unit pixels UPX, a plurality of scan lines SL, a plurality of emission control lines EL, and a plurality of data lines DL.

The plurality of unit pixels UPX may be arranged in a matrix form in the first direction DR1 and the second direction DR2. The plurality of scan lines SL and the plurality of emission control lines EL may extend in the first direction DR1, while being arranged in the second direction DR2. The plurality of data lines DL may extend in the second direction DR2, while being arranged in the first direction DR1.

The plurality of scan lines SL may include a plurality of write scan lines GWL, a plurality of control scan lines GCL, and a plurality of bias scan lines GBL. The plurality of emission control lines EL may include a plurality of first emission control lines EL1 and a plurality of second emission control lines EL2.

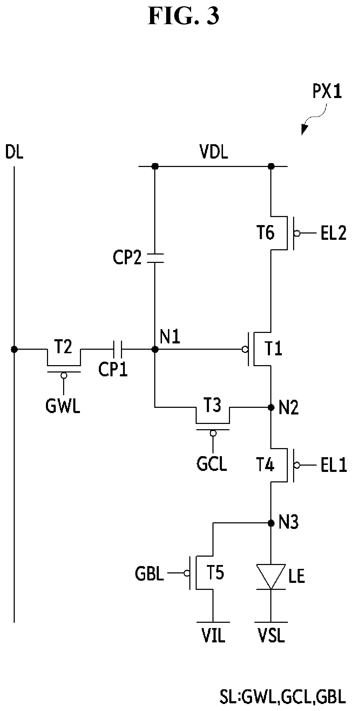

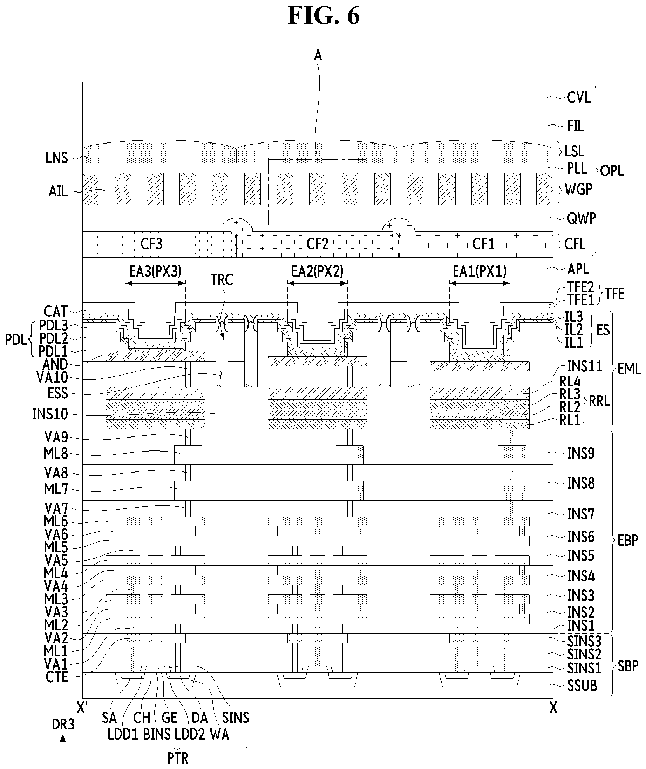

Each of a plurality of unit pixels UPX may include a plurality of pixels PX1, PX2, and PX3. The plurality of pixels PX1, PX2, and PX3 may include a plurality of pixel transistors as shown in FIG. 3, and the plurality of pixel transistors are formed through a semiconductor process and may be disposed on a semiconductor substrate SSUB (see FIG.6). For example, the plurality of pixel transistors of a data driver 700 may be formed of complementary metal oxide semiconductor (CMOS).

Each of the plurality of pixels PX1, PX2, and PX3 may be connected to any one of the plurality of write scan lines GWL, any one of the plurality of control scan lines GCL, any one of the plurality of bias scan lines GBL, any one of the plurality of first emission control lines EL1, any one of the plurality of second emission control lines EL2, and any one of the plurality of data lines DL. Each of the plurality of pixels PX1, PX2, and PX3 may receive a data voltage of the data line DL in response to a write scan signal of the write scan line GWL, and emit light from the light-emitting element according to the data voltage.

The non-display area NDA may include a scan driver 610, an emission driver 620, and the data driver 700.

The scan driver 610 may include a plurality of scan transistors, and the emission driver 620 may include a plurality of light-emitting transistors. The plurality of scan transistors and the plurality of light-emitting transistors may be formed on the semiconductor substrate SSUB (see FIG. 6) through a semiconductor process. For example, the plurality of scan transistors and the plurality of light-emitting transistors may be formed of CMOS. Although it is illustrated in FIG. 2 that the scan driver 610 is disposed on the left side of the display area DAA and the emission driver 620 is disposed on the right side of the display area DAA, the present disclosure is not limited thereto. For example, the scan driver 610 and the emission driver 620 may be disposed on both the left side and the right side of the display area DAA.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 may include a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines EL1. The second emission control driver 622 may generate second emission control signals according to the emission timing control signal ECS and sequentially output them to the second emission control lines EL2.

The data driver 700 may include a plurality of data transistors, and the plurality of data transistors may be formed on the semiconductor substrate SSUB (see FIG. 6) through a semiconductor process. For example, the plurality of data transistors may be formed of CMOS.

The data driver 700 may receive digital video data DATA and a data timing control signal DCS from the timing control circuit 400. The data driver 700 converts the digital video data DATA into analog data voltages according to the data timing control signal DCS and outputs the analog data voltages to the data lines DL. In this case, the pixels PX1, PX2, and PX3 are selected by the write scan signal of the scan driver 610, and data voltages may be supplied to the selected pixels PX1, PX2, and PX3.

The heat dissipation layer 200 may overlap the display panel 100 in a third direction DR3, which is a thickness direction of the display panel 100. The heat dissipation layer 200 may be disposed on one surface of the display panel 100, for example, on the rear surface thereof. The heat dissipation layer 200 serves to dissipate heat generated from the display panel 100. The heat dissipation layer 200 may include a metal layer such as graphite, silver (Ag), copper (Cu), or aluminum (Al) having high thermal conductivity.

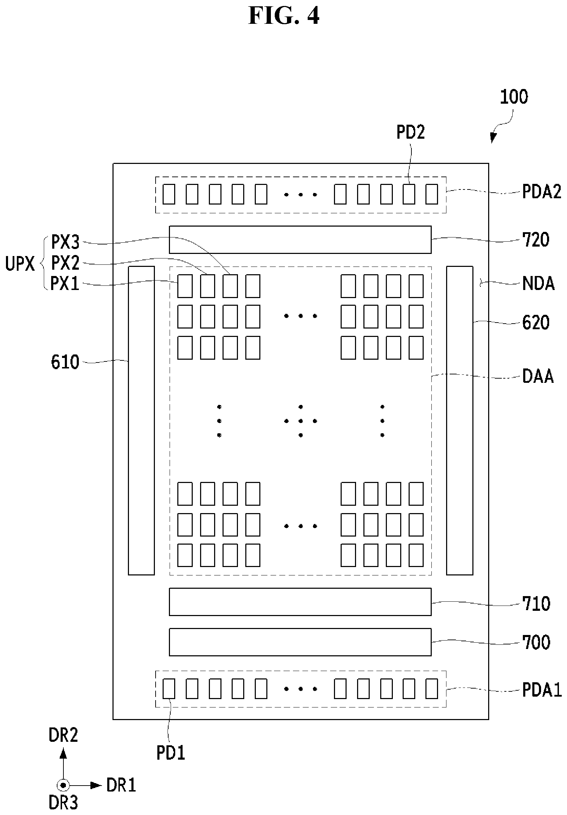

The circuit board 300 may be electrically connected to a plurality of first pads PD1 (see FIG. 4) of a first pad portion PDA1 (see FIG. 4) of the display panel 100 by using a conductive adhesive member such as an anisotropic conductive film. The circuit board 300 may be a flexible printed circuit board with a flexible material, or a flexible film. Although the circuit board 300 is illustrated in FIG. 1 as being unfolded, the circuit board 300 may be bent. In this case, one end of the circuit board 300 may be disposed on the rear surface of the display panel 100 and/or the rear surface of the heat dissipation layer 200. One end of the circuit board 300 may be an opposite end of the other end of the circuit board 300 connected to the plurality of first pads PD1 (see FIG. 4) of the first pad portion PDA1 (see FIG. 4) of the display panel 100 by using a conductive adhesive member.

The timing control circuit 400 may receive digital video data and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data and the data timing control signal DCS to the data driver 700.

The power supply circuit 500 may generate a plurality of panel driving voltages according to a power voltage from the outside. For example, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT will be described later in conjunction with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

In an embodiment, each of the timing control circuit 400 and the power supply circuit 500 may be disposed in the non-display area NDA of the display panel 100, similarly to the scan driver 610, the emission driver 620, and the data driver 700. In this case, the timing control circuit 400 may include a plurality of timing transistors, and each power supply circuit 500 may include a plurality of power transistors. The plurality of timing transistors and the plurality of power transistors may be formed on the semiconductor substrate SSUB (see FIG. 6) through a semiconductor process. For example, the plurality of timing transistors and the plurality of power transistors may be formed of CMOS. Each of the timing control circuit 400 and the power supply circuit 500 may be disposed between the data driver 700 and the first pad portion PDA1 (see FIG. 4).

FIG. 3 is an equivalent circuit diagram of a first pixel PX1 according to an embodiment.

Referring to FIG. 3, the first pixel PX1 may be connected to the write scan line GWL, the control scan line GCL, the bias scan line GBL, the first emission control line EL1, the second emission control line EL2, and the data line DL. In addition, the first pixel PX1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The first pixel PX1 may include a plurality of transistors T1 to T6, a light-emitting element LE, a first capacitor CP1, and a second capacitor CP2.

The light-emitting element LE emits light in response to a driving current flowing through the channel of the first transistor T1. The emission amount of the light-emitting element LE may be proportional to the driving current. The light-emitting element LE may be disposed between the fourth transistor T4 and the first driving voltage line VSL. The first electrode of the light-emitting element LE may be connected to the drain electrode of the fourth transistor T4, and the second electrode thereof may be connected to the first driving voltage line VSL. The first electrode of the light-emitting element LE may be an anode electrode, and the second electrode of the light-emitting element LE may be a cathode electrode. The light-emitting element LE may be an organic light-emitting diode including a first electrode, a second electrode, and an organic light-emitting layer disposed between the first electrode and the second electrode, but the present disclosure is not limited thereto. For example, the light-emitting element LE may be an inorganic light-emitting element including a first electrode, a second electrode, and an inorganic semiconductor disposed between the first electrode and the second electrode, in which case the light-emitting element LE may be a micro light-emitting diode.

The first transistor T1 may be a driving transistor that controls a source-drain current (hereinafter referred to as "driving current") flowing between the source electrode and the drain electrode thereof according to a voltage applied to the gate electrode thereof. The first transistor T1 may include a gate electrode connected to a first node N1, a source electrode connected to the drain electrode of the sixth transistor T6, and a drain electrode connected to a second node N2.

The second transistor T2 may be disposed between one electrode of the first capacitor CP1 and the data line DL. The second transistor T2 is turned on by the write scan signal of the write scan line GWL to connect the one electrode of the first capacitor CP1 to the data line DL. Accordingly, the data voltage of the data line DL may be applied to the one electrode of the first capacitor CP1. The second transistor T2 may include a gate electrode connected to the write scan line GWL, a source electrode connected to the data line DL, and a drain electrode connected to the one electrode of the first capacitor CP1.

The third transistor T3 may be disposed between the first node N1 and the second node N2. The third transistor T3 is turned on by the write control signal of the write control line GCL to connect the first node N1 to the second node N2. For this reason, since the gate electrode and the source electrode of the first transistor T1 are connected, the first transistor T1 may operate like a diode. The third transistor T3 may include a gate electrode connected to the write control line GCL, a source electrode connected to the second node N2, and a drain electrode connected to the first node N1.

The fourth transistor T4 may be connected between the second node N2 and a third node N3. The fourth transistor T4 is turned on by the first emission control signal of the first emission control line EL1 to connect the second node N2 to the third node N3. Accordingly, the driving current of the first transistor T1 may be supplied to the light-emitting element LE. The fourth transistor T4 may include a gate electrode connected to the first emission control line EL1, a source electrode connected to the second node N2, and a drain electrode connected to the third node N3.

The fifth transistor T5 may be disposed between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light-emitting element LE. The fifth transistor T5 may include a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 may include a gate electrode connected to the second emission control line EL2, a source electrode connected to the second driving voltage line VDL, and a drain electrode connected to the source electrode of the first transistor T1.

The first capacitor CP1 is formed between the first node N1 and the drain electrode of the second transistor T2. The first capacitor CP1 may include one electrode connected to the drain electrode of the second transistor T2 and the other electrode connected to the first node N1.

The second capacitor CP2 is formed between the gate electrode of the first transistor T1 and the second driving voltage line VDL. The second capacitor CP2 may include one electrode connected to the gate electrode of the first transistor T1 and the other electrode connected to the second driving voltage line VDL.

The first node N1 is a junction between the gate electrode of the first transistor T1, the drain electrode of the third transistor T3, the other electrode of the first capacitor CP1, and the one electrode of the second capacitor CP2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light-emitting element LE.

Each of the first to sixth transistors T1 to T6 may be a metal-oxide-semiconductor field effect transistor (MOSFET). For example, each of the first to sixth transistors T1 to T6 may be a P-type MOSFET, but the present disclosure is not limited thereto. Each of the first to sixth transistors T1 to T6 may be an N-type MOSFET. In an embodiment, some of the first to sixth transistors T1 to T6 may be P-type MOSFETs, and each of the remaining transistors may be an N-type MOSFET.

Although it is illustrated in FIG. 3 that the first pixel PX1 includes the six transistors T1 to T6 and the two capacitors C1 and C2, it should be noted that the equivalent circuit diagram of the first pixel PX1 is not limited to the example shown in FIG. 3. For example, the number of the transistors and the number of the capacitors of the first pixel PX1 are not limited to the example shown in FIG. 3.

In addition, the equivalent circuit diagram of a second pixel PX2 and the equivalent circuit diagram of a third pixel PX3 may be substantially the same as the equivalent circuit diagram of the first pixel PX1 described in conjunction with FIG. 3. Thus, in the present disclosure, description of the equivalent circuit diagram of the second pixel PX2 and the equivalent circuit diagram of the third pixel PX3 will be omitted.

FIG. 4 is a layout diagram illustrating an example of a display panel 100 according to an embodiment.

Referring to FIG. 4, the display area DAA of the display panel 100 according to an embodiment may include the plurality of pixels PX arranged in a matrix form. The non-display area NDA of the display panel 100 according to an embodiment may include the scan driver 610, the emission driver 620, the data driver 700, a first distribution circuit 710, a second distribution circuit 720, the first pad portion PDA1, and a second pad portion PDA2.

The scan driver 610 may be disposed on a first side of the display area DAA, and the emission driver 620 may be disposed on a second side of the display area DAA. For example, the scan driver 610 may be disposed on one side of the display area DAA in the first direction DR1, and the emission driver 620 may be disposed on the other side of the display area DAA in the first direction DR1. That is, the scan driver 610 may be disposed on the left side of the display area DAA, and the emission driver 620 may be disposed on the right side of the display area DAA. However, the present disclosure is not limited thereto, and the scan driver 610 and the emission driver 620 may be disposed on both the first side and the second side of the display area DAA.

The first pad portion PDA1 may include the plurality of first pads PD1 connected to pads or bumps of the circuit board 300 through a conductive adhesive member. The first pad portion PDA1 may be disposed on a third side of the display area DAA. For example, the first pad portion PDA1 may be disposed on one side of the display area DAA in the second direction DR2.

The first pad portion PDA1 may be disposed outside the data driver 700 in the second direction DR2. That is, the first pad portion PDA1 may be disposed closer to the edge of the display panel 100 than the data driver 700.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board made of a rigid material or a flexible printed circuit board made of a flexible material.

The first distribution circuit 710 distributes data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. The first distribution circuit 710 may be disposed on the third side of the display area DAA of the display panel 100. For example, the first distribution circuit 710 may be disposed on one side of the display area DAA in the second direction DR2. That is, the first distribution circuit 710 may be disposed on the lower side of the display area DAA.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be disposed on a fourth side of the display area DAA of the display panel 100. For example, the second distribution circuit 720 may be disposed on the other side of the display area DAA in the second direction DR2. That is, the second distribution circuit 720 may be disposed on the upper side of the display area DAA.

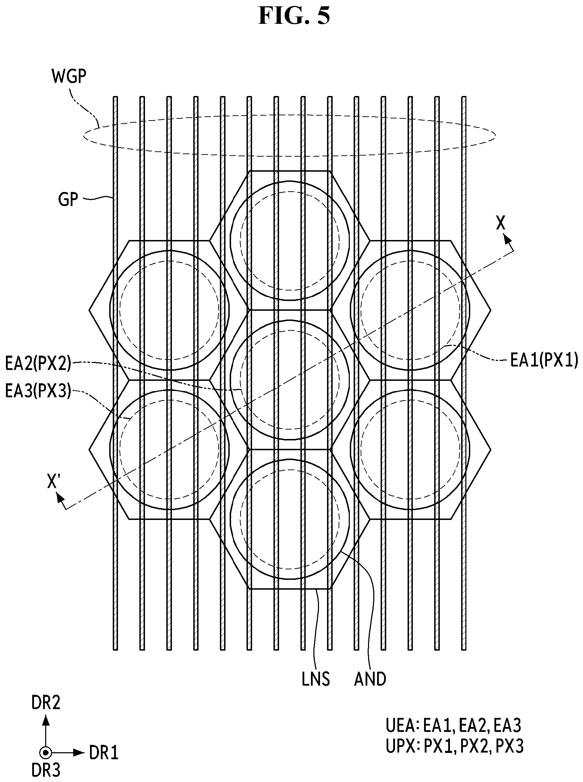

FIG. 5 is a layout diagram showing embodiments of the display area of FIG. 4.

Referring to FIG. 5, each of the plurality of unit pixels UPX may include a first emission area EA1 as an emission area of the first pixel PX1, a second emission area EA2 as an emission area of the second pixel PX2, and a third emission area EA3 as an emission area of the third pixel PX3. In other words, the unit pixel UPX may include a unit emission area UEA, and the unit emission area UEA may include the first emission area EA1, the second emission area EA2, and the third emission area EA3 described above.

Each of the plurality of unit pixels UPX may include the first emission area EA1 as an emission area of the first pixel PX1, the second emission area EA2 as an emission area of the second pixel PX2, and the third emission area EA3 as an emission area of the third pixel PX3.

Each of the first emission area EA1, the second emission area EA2, and the third emission area EA3 may have a polygonal, circular, elliptical, or irregular planar shape, but the shape of each of the emission areas EA1, EA2, and EA3 is not limited thereto.

The maximum length of the first emission area EA1 in the first direction DR1 may be less than the maximum length of the second emission area EA2 in the first direction DR1 and the maximum length of the third emission area EA3 in the first direction DR1. The maximum length of the second emission area EA2 in the first direction DR1 and the maximum length of the third emission area EA3 in the first direction DR1 may be substantially the same.

The maximum length of the first emission area EA1 in the second direction DR2 may be greater than the maximum length of the second emission area EA2 in the second direction DR2 and the maximum length of the third emission area EA3 in the second direction DR2. The maximum length of the second emission area EA2 in the second direction DR2 may be greater than the maximum length of the third emission area EA3 in the second direction DR2. The maximum length of the first emission area EA1 in the second direction DR2 may be less than the maximum length of the second emission area EA2 in the second direction DR2.

The first emission area EA1, the second emission area EA2, and the third emission area EA3 may have, in plan view, a hexagonal shape formed of six straight lines as shown in FIG. 5, but the present disclosure is not limited thereto. The first emission area EA1, the second emission area EA2, and the third emission area EA3 may have a polygonal shape other than a hexagon, a circular shape, an elliptical shape, or an atypical shape in plan view.

As shown in FIG. 5, in each of the plurality of unit pixels UPX, the first emission area EA1 and the second emission area EA2 may be adjacent to each other in the first direction DR1. Further, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

The first emission area EA1 may emit light of a first color, the second emission area EA2 may emit light of a second color, and the third emission area EA3 may emit light of a third color. Here, the light of the first color may be light of a blue wavelength band, the light of the second color may be light of a green wavelength band, and the light of the third color may be light of a red wavelength band. For example, the blue wavelength band may be a wavelength band of light whose main peak wavelength is in the range of about 380 nm to about 480 nm, the green wavelength band may be a wavelength band of light whose main peak wavelength is in the range of about 480 nm to about 560 nm, and the red wavelength band may be a wavelength band of light whose main peak wavelength is in the range of about 600 nm to about 750 nm.

It is exemplified in FIG. 5 that each of the plurality of unit pixels UPX includes three emission areas EA1, EA2, and EA3, but the present disclosure is not limited thereto. That is, each of the plurality of unit pixels UPX may include four emission areas.

In addition, the disposition of the emission areas of the plurality of unit pixels UPX is not limited to that illustrated in FIG. 5. For example, the emission areas of the plurality of unit pixels UPX may be disposed in a stripe structure in which the emission areas are arranged in the first direction DR1, a PenTile^{®} structure in which the emission areas are arranged in a diamond shape, or a hexagonal structure in which the emission areas having, in plan view, a hexagonal shape are arranged as shown in FIG. 5.

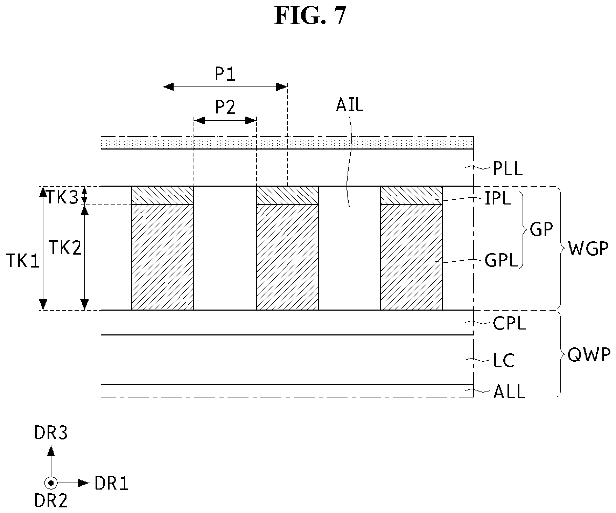

FIG. 6 is a cross-sectional view illustrating an example of the display panel 100 taken along line X-X' of FIG. 5. FIG. 7 is an enlarged view of area A of FIG. 6.

Referring to FIGS. 6 and 7, the display panel 100 may include a semiconductor backplane SBP, a light-emitting element backplane EBP, a display element layer EML, an encapsulation layer TFE, and an optical layer OPL. The semiconductor backplane SBP and light-emitting element backplane EBP may be referred to as substrates.

The semiconductor backplane SBP may include the semiconductor substrate SSUB including a plurality of pixel transistors PTR, a plurality of semiconductor insulating films covering the plurality of pixel transistors PTR, and a plurality of contact terminals CTE electrically connected to the plurality of pixel transistors PTR, respectively. The plurality of pixel transistors PTR may be the first to sixth transistors T1 to T6 described with reference to FIG. 3.

The semiconductor substrate SSUB may be a silicon substrate, a germanium substrate, or a silicon-germanium substrate. The semiconductor substrate SSUB may be a substrate doped with a first type impurity. A plurality of well regions WA may be disposed on the top surface of the semiconductor substrate SSUB. The plurality of well regions WA may be regions doped with a second type impurity. The second type impurity may be different from the aforementioned first type impurity. For example, when the first type impurity is a p-type impurity, the second type impurity may be an n-type impurity. In an embodiment, when the first type impurity is an n-type impurity, the second type impurity may be a p-type impurity.

Each of the plurality of well regions WA may include a source region SA corresponding to the source electrode of the pixel transistor PTR, a drain region DA corresponding to the drain electrode thereof, and a channel region CH disposed between the source region SA and the drain region DA.

A lower insulating film BINS may be disposed between a gate electrode GE and the well region WA. A side insulating film SINS may be disposed on the side surface of the gate electrode GE. The side insulating film SINS may be disposed on the lower insulating film BINS.

Each of the source region SA and the drain region DA may be a region doped with the first type impurity. The gate electrode GE of the pixel transistor PTR may overlap the well region WA in the third direction DR3. The channel region CH may overlap the gate electrode GE in the third direction DR3. The source region SA may be disposed on one side of the gate electrode GE, and the drain region DA may be disposed on the other side of the gate electrode GE.

Each of the plurality of well regions WA may further include a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than the source region SA due to the lower insulating film BINS. The second low-concentration impurity region LDD2 may be a region having a lower impurity concentration than the drain region DA due to the lower insulating film BINS. The distance between the source region SA and the drain region DA may increase due to the presence of the first low-concentration impurity region LDD1 and the second low-concentration impurity region LDD2. Therefore, the length of the channel region CH of each of the pixel transistors PTR may increase, so that punch-through and hot carrier phenomena that might be caused by a short channel may be reduced or prevented.

A first semiconductor insulating film SINS1 may be disposed on the semiconductor substrate SSUB. The first semiconductor insulating film SINS1 may be formed of silicon carbonitride (SiCN) or a silicon oxide (SiOx)-based inorganic film, but the present disclosure is not limited thereto.

A second semiconductor insulating film SINS2 may be disposed on the first semiconductor insulating film SINS1. The second semiconductor insulating film SINS2 may be formed of a silicon oxide (SiOx)-based inorganic film, but the present disclosure is not limited thereto.

The plurality of contact terminals CTE may be disposed on the second semiconductor insulating film SINS2. Each of the plurality of contact terminals CTE may be connected to any one of the gate electrode GE, the source region SA, and the drain region DA of each of the pixel transistors PTR through a hole penetrating the first semiconductor insulating film SINS1 and the second semiconductor insulating film SINS2. The plurality of contact terminals CTE may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them.

A third semiconductor insulating film SINS3 may be disposed on a side surface of each of the plurality of contact terminals CTE. The top surface of each of the plurality of contact terminals CTE may be exposed without being covered by the third semiconductor insulating film SINS3. The third semiconductor insulating film SINS3 may be formed of a silicon oxide (SiOx)-based inorganic film, but the present disclosure is not limited thereto.

The semiconductor substrate SSUB may be replaced with a glass substrate or a polymer resin substrate such as polyimide. In this case, thin film transistors may be disposed on the glass substrate or the polymer resin substrate. The glass substrate may be a rigid substrate that does not bend, and the polymer resin substrate may be a flexible substrate that can be bent or curved.

The light-emitting element backplane EBP may include a plurality of conductive layers ML1 to ML8, a plurality of vias VA1 to VA9, and a plurality of insulating films INS1 to INS9. In addition, the light-emitting element backplane EBP may include a plurality of insulating films INS1 to INS11 disposed between the first to eighth conductive layers ML1 to ML8.

The first to eighth conductive layers ML1 to ML8 serve to connect the plurality of contact terminals CTE exposed from the semiconductor backplane SBP to thereby implement the circuit of the first pixel PX1 shown in FIG. 4. For example, the first to sixth transistors T1 to T6 are merely formed in the semiconductor backplane SBP, and the connection of the first to sixth transistors T1 to T6 and the first and second capacitors C1 and C2 is accomplished through the first to eighth conductive layers ML1 to ML8. In addition, the connection between the drain region corresponding to the drain electrode of the fourth transistor T4, the source region corresponding to the source electrode of the fifth transistor T5, and the first electrode of the light-emitting element LE is also accomplished through the first to eighth conductive layers ML1 to ML8.

The first insulating film INS1 may be disposed on the semiconductor backplane SBP. Each of the first vias VA1 may penetrate the first insulating film INS1 and be connected to the contact terminal CTE exposed from the semiconductor backplane SBP. Each of the first conductive layers ML1 may be disposed on the first insulating film INS1 and may be connected to the first via VA1.

The second insulating film INS2 may be disposed on the first insulating film INS1 and the first conductive layers ML1. Each of the second vias VA2 may penetrate the second insulating film INS2 and be connected to the exposed first conductive layer ML1. Each of the second conductive layers ML2 may be disposed on the second insulating film INS2 and may be connected to the second via VA2.

The third insulating film INS3 may be disposed on the second insulating film INS2 and the second conductive layers ML2. Each of the third vias VA3 may penetrate the third insulating film INS3 and be connected to the exposed second conductive layer ML2. Each of the third conductive layers ML3 may be disposed on the third insulating film INS3 and may be connected to the third via VA3.

The fourth insulating film INS4 may be disposed on the third insulating film INS3 and the third conductive layers ML3. Each of the fourth vias VA4 may penetrate the fourth insulating film INS4 and be connected to the exposed third conductive layer ML3. Each of the fourth conductive layers ML4 may be disposed on the fourth insulating film INS4 and may be connected to the fourth via VA4.

The fifth insulating film INS5 may be disposed on the fourth insulating film INS4 and the fourth conductive layers ML4. Each of the fifth vias VA5 may penetrate the fifth insulating film INS5 and be connected to the exposed fourth conductive layer ML4. Each of the fifth conductive layers ML5 may be disposed on the fifth insulating film INS5 and may be connected to the fifth via VA5.

The sixth insulating film INS6 may be disposed on the fifth insulating film INS5 and the fifth conductive layers ML5. Each of the sixth vias VA6 may penetrate the sixth insulating film INS6 and be connected to the exposed fifth conductive layer ML5. Each of the sixth conductive layers ML6 may be disposed on the sixth insulating film INS6 and may be connected to the sixth via VA6.

The seventh insulating film INS7 may be disposed on the sixth insulating film INS6 and the sixth conductive layers ML6. Each of the seventh vias VA7 may penetrate the seventh insulating film INS7 and be connected to the exposed sixth conductive layer ML6. Each of the seventh conductive layers ML7 may be disposed on the seventh insulating film INS7 and may be connected to the seventh via VA7.

The eighth insulating film INS8 may be disposed on the seventh insulating film INS7 and the seventh conductive layers ML7. Each of the eighth vias VA8 may penetrate the eighth insulating film INS8 and be connected to the exposed seventh conductive layer ML7. Each of the eighth conductive layers ML8 may be disposed on the eighth insulating film INS8 and may be connected to the eighth via VA8.

The first to eighth conductive layers ML1 to ML8 and the first to eighth vias VA1 to VA8 may be formed of substantially the same material. The first to eighth conductive layers ML1 to ML8 and the first to eighth vias VA1 to VA8 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. The first to eighth vias VA1 to VA8 may be made of substantially the same material. First to eighth insulating films INS1 to INS8 may be formed of a silicon oxide (SiOx)-based inorganic film, but the present disclosure is not limited thereto.

The thicknesses of the first conductive layer ML1, the second conductive layer ML2, the third conductive layer ML3, the fourth conductive layer ML4, the fifth conductive layer ML5, and the sixth conductive layer ML6 may be greater than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1360 Å. The thickness of each of the second conductive layer ML2, the third conductive layer ML3, the fourth conductive layer ML4, the fifth conductive layer ML5, and the sixth conductive layer ML6 may be approximately 1440 Å. The thickness of each of the first via VA1, the second via VA2, the third via VA3, the fourth via VA4, the fifth via VA5, and the sixth via VA6 may be approximately 1150 Å.

The thickness of each of the seventh conductive layer ML7 and the eighth conductive layer ML8 may be greater than the thickness of each of the first conductive layer ML1, the second conductive layer ML2, the third conductive layer ML3, the fourth conductive layer ML4, the fifth conductive layer ML5, and the sixth conductive layer ML6. The thickness of the seventh conductive layer ML7 and the thickness of the eighth conductive layer ML8 may be greater than the thickness of the seventh via VA7 and the thickness of the eighth via VA8, respectively. The thickness of each of the seventh via VA7 and the eighth via VA8 may be greater than the thickness of each of the first via VA1, the second via VA2, the third via VA3, the fourth via VA4, the fifth via VA5, and the sixth via VA6. The thickness of the seventh conductive layer ML7 and the thickness of the eighth conductive layer ML8 may be substantially the same. For example, the thickness of each of the seventh conductive layer ML7 and the eighth conductive layer ML8 may be approximately 9000 Å. The thickness of each of the seventh via VA7 and the eighth via VA8 may be approximately 6000 Å.

The ninth insulating film INS9 may be disposed on the eighth insulating film INS8 and the eighth conductive layer ML8. The ninth insulating film INS9 may be formed of a silicon oxide (SiOx)-based inorganic film, but the present disclosure is not limited thereto.

Each of the ninth vias VA9 may penetrate the ninth insulating film INS9 and be connected to the exposed eighth conductive layer ML8. The ninth vias VA9 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. The thickness of the ninth via VA9 may be approximately 16500 Å.

The display element layer EML may be disposed on the light-emitting element backplane EBP. The display element layer EML may include light-emitting elements LE each including a reflective electrode layer RRL, tenth and eleventh insulating films INS10 and INS11, a tenth via VA10, a first electrode AND, a light-emitting stack ES, and a second electrode CAT; a pixel defining film PDL; and a plurality of trenches TRC.

The reflective electrode layer RRL may be disposed on the ninth insulating film INS9. The reflective electrode layer RRL may include at least one reflective electrode RL1, RL2, RL3, and RL4. For example, the reflective electrode layer RRL may include first to fourth reflective electrodes RL1, RL2, RL3, and RL4 as shown in FIG. 6.

Each of the first reflective electrodes RL1 may be disposed on the ninth insulating film INS9, and may be connected to the ninth via VA9. The first reflective electrodes RL1 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the first reflective electrodes RL1 may include titanium nitride (TiN).

Each of the second reflective electrodes RL2 may be disposed on the first reflective electrode RL1. The second reflective electrodes RL2 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the second reflective electrodes RL2 may include aluminum (Al).

Each of the third reflective electrodes RL3 may be disposed on the second reflective electrode RL2. The third reflective electrodes RL3 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the third reflective electrodes RL3 may include titanium nitride (TiN).

Each of the fourth reflective electrodes RL4 may be disposed on the third reflective electrode RL3. The fourth reflective electrodes RL4 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the fourth reflective electrodes RL4 may include titanium (Ti).

Since the second reflective electrode RL2 is an electrode that substantially reflects light from the light-emitting elements LE, the thickness of the second reflective electrode RL2 may be greater than the thickness of each of the first reflective electrode RL1, the third reflective electrode RL3, and the fourth reflective electrode RL4. For example, the thickness of each of the first reflective electrode RL1, the third reflective electrode RL3, and the fourth reflective electrode RL4 may be approximately 100 Å, and the thickness of the second reflective electrode RL2 may be approximately 850 Å.

The tenth insulating film INS10 may be disposed on the ninth insulating film INS9. The tenth insulating film INS10 may be disposed between the reflective electrode layers RRL adjacent to each other in a horizontal direction. The tenth insulating film INS10 may be disposed on the reflective electrode layer RRL in the third pixel PX3. The tenth insulating film INS10 may be formed of a silicon oxide (SiOx)-based inorganic film, but the present disclosure is not limited thereto.

The eleventh insulating film INS11 may be disposed on the tenth insulating film INS10 and the reflective electrode layer RRL. The eleventh insulating film INS11 may be formed of a silicon oxide (SiOx)-based inorganic film, but the present disclosure is not limited thereto. The tenth insulating film INS 10 and the eleventh insulating film INS11 may be an optical auxiliary layer through which light reflected by the reflective electrode layer RRL passes, among light emitted from the light-emitting elements LE.

In order to match the resonance distance of the light emitted from the light-emitting elements LE in at least one of the first pixel PX1, the second pixel PX2, or the third pixel PX3, the tenth insulating film INS 10 and the eleventh insulating film INS11 may not be disposed under the first electrode AND of the first pixel PX1. The first electrode AND of the first pixel PX1 may be directly disposed on the reflective electrode layer RRL. The eleventh insulating film INS11 may be disposed under the first electrode AND of the second pixel PX2. The tenth insulating film INS10 and the eleventh insulating film INS11 may be disposed under the first electrode AND of the third pixel PX3.

In summary, the distance between the first electrode AND and the reflective electrode layer RRL may be different in the first pixel PX1, the second pixel PX2, and the third pixel PX3. In order to adjust the distance from the reflective electrode layer RRL to the second electrode CAT according to the main wavelength of the light emitted from each of the first pixel PX1, the second pixel PX2, and the third pixel PX3, the presence or absence of the tenth insulating film INS10 and the eleventh insulating film INS11 may be set in each of the first pixel PX1, the second pixel PX2, and the third pixel PX3. For example, it is illustrated in FIG. 6 that the distance between the first electrode AND and the reflective electrode layer RRL in the third pixel PX3 is greater than the distance between the first electrode AND and the reflective electrode layer RRL in the second pixel PX2 and the distance between the first electrode AND and the reflective electrode layer RRL in the first pixel PX1, and the distance between the first electrode AND and the reflective electrode layer RRL in the second pixel PX2 is greater than the distance between the first electrode AND and the reflective electrode layer RRL in the first pixel PX1, but the present disclosure is not limited thereto.

In addition, although the tenth insulating film INS10 and the eleventh insulating film INS11 are illustrated in the present disclosure, a twelfth insulating film disposed under the first electrode AND of the first pixel PX1 may be added. In this case, the eleventh insulating film INS11 and the twelfth insulating film may be disposed under the first electrode AND of the second pixel PX2, and the tenth insulating film INS10, the eleventh insulating film INS11, and the twelfth insulating film may be disposed under the first electrode AND of the third pixel PX3.

Each of the tenth vias VA10 may penetrate the tenth insulating film INS10 and/or the eleventh insulating film INS11 in the second pixel PX2 and the third pixel PX3 and may be connected to the exposed eight conductive layer ML8. The tenth vias VA10 may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. The thickness of the tenth via VA10 in the second pixel PX2 may be less than the thickness of the tenth via VA10 in the third pixel PX3.

The first electrode AND of each of the light-emitting elements LE may be disposed on the tenth insulating film INS10 and connected to the tenth via VA10. The first electrode AND of each of the light-emitting elements LE may be connected to the drain region DA or source region SA of the pixel transistor PTR through the tenth via VA10, the first to fourth reflective electrodes RL1 to RL4, the first to ninth vias VA1 to VA9, the first to eighth conductive layers ML1 to ML8, and the contact terminal CTE. The first electrode AND of each of the light-emitting elements LE may be formed of any one of copper (Cu), aluminum (Al), tungsten (W), molybdenum (Mo), chromium (Cr), gold (Au), titanium (Ti), nickel (Ni), and neodymium (Nd), or an alloy including any one of them. For example, the first electrode AND of each of the light-emitting elements LE may be titanium nitride (TiN).

The pixel defining film PDL may be disposed on a portion of the first electrode AND of each of the light-emitting elements LE. The pixel defining film PDL may cover the edge of the first electrode AND of each of the light-emitting elements LE. The pixel defining film PDL may serve to partition the first emission areas EA1, the second emission areas EA2, and the third emission areas EA3.

The first emission area EA1 may be defined as an area in which the first electrode AND, the light-emitting stack ES, and the second electrode CAT are sequentially stacked in the first pixel PX1 to emit light. The second emission area EA2 may be defined as an area in which the first electrode AND, the light-emitting stack ES, and the second electrode CAT are sequentially stacked in the second pixel PX2 to emit light. The third emission area EA3 may be defined as an area in which the first electrode AND, the light-emitting stack ES, and the second electrode CAT are sequentially stacked in the third pixel PX3 to emit light.

The pixel defining film PDL may include first to third pixel defining films PDL1, PDL2, and PDL3. The first pixel defining film PDL1 may be disposed on the edge of the first electrode AND of each of the light-emitting elements LE, the second pixel defining film PDL2 may be disposed on the first pixel defining film PDL1, and the third pixel defining film PDL3 may be disposed on the second pixel defining film PDL2. The first pixel defining film PDL1, the second pixel defining film PDL2, and the third pixel defining film PDL3 may be formed of a silicon oxide (SiOₓ)-based inorganic film, but the present disclosure is not limited thereto. The first pixel defining film PDL1, the second pixel defining film PDL2, and the third pixel defining film PDL3 may each have a thickness of about 500 Å.

When the first pixel defining film PDL1, the second pixel defining film PDL2, and the third pixel defining film PDL3 are formed as one pixel defining film, the height of the one pixel defining film increases, so that a first encapsulation inorganic film TFE1 may be cut off due to step coverage. Step coverage refers to the ratio of the degree of thin film coated on an inclined portion to the degree of thin film coated on a flat portion. The lower the step coverage, the more likely it is that the thin film will be cut off at inclined portions.

Therefore, in order to prevent the first encapsulation inorganic film TFE1 from being cut off due to the step coverage, the first pixel defining film PDL1, the second pixel defining film PDL2, and the third pixel defining film PDL3 may have a cross-sectional structure having a stepped portion. For example, the width of the first pixel defining film PDL1 may be greater than the width of the second pixel defining film PDL2 and the width of the third pixel defining film PDL3, and the width of the second pixel defining film PDL2 may be greater than the width of the third pixel defining film PDL3. The width of the first pixel defining film PDL1 refers to the horizontal length of the first pixel defining film PDL1 defined in the first direction DR1 and the second direction DR2.

Each of the plurality of trenches TRC may penetrate the first pixel defining film PDL1, the second pixel defining film PDL2, and the third pixel defining film PDL3. Furthermore, each of the plurality of trenches TRC may penetrate the eleventh insulating film INS11. The tenth insulating film INS10 may be partially recessed at each of the plurality of trenches TRC.

At least one trench TRC may be disposed between adjacent pixels PX1, PX2, and PX3. Although FIG. 6 illustrates that two trenches TRC are disposed between adjacent pixels PX1, PX2, and PX3, the present disclosure is not limited thereto.

The light-emitting stack ES may include a plurality of intermediate layers. FIG. 6 illustrates that the light-emitting stack ES has a three-tandem structure including a first stack layer IL1, a second stack layer IL2, and a third stack layer IL3, but the present disclosure is not limited thereto. For example, the light-emitting stack ES may have a two-tandem structure including two intermediate layers.

In the three-tandem structure, the light-emitting stack ES may have a tandem structure including a plurality of stack layers IL1, IL2, and IL3 that emit different lights. For example, the light-emitting stack ES may include the first stack layer IL1 that emits light of the first color, the second stack layer IL2 that emits light of the second color, and the third stack layer IL3 that emits light of the third color. The first stack layer IL1, the second stack layer IL2, and the third stack layer IL3 may be sequentially stacked.

The first stack layer IL1 may have a structure in which a first hole transport layer, a first organic light-emitting layer that emits light of the first color, and a first electron transport layer are sequentially stacked. The second stack layer IL2 may have a structure in which a second hole transport layer, a second organic light-emitting layer that emits light of the second color, and a second electron transport layer are sequentially stacked. The third stack layer IL3 may have a structure in which a third hole transport layer, a third organic light-emitting layer that emits light of the third color, and a third electron transport layer are sequentially stacked. In this case, the light-emitting stack may emit white light in which the light of the first color (e.g., red light) from the first organic light-emitting layer, the light of the second color (e.g., green light) from the second organic light-emitting layer, and the light of the third color (e.g., blue light) from the third organic light-emitting layer are mixed. Accordingly, the white light may be emitted from each of the first emission area EA1, the second emission area EA2, and the third emission area EA3. Here, the white light having passed through the first emission area EA1 may be incident on a first color filter CF1, the white light having passed through the second emission area EA2 may be incident on a second color filter CF2, and the white light having passed through the third emission area EA3 may be incident on a third color filter CF3.

A first charge generation layer for supplying charges to the second stack layer IL2 and supplying electrons to the first stack layer IL1 may be disposed between the first stack layer IL1 and the second stack layer IL2. The first charge generation layer may include an N-type charge generation layer that supplies electrons to the first stack layer IL1 and a P-type charge generation layer that supplies holes to the second stack layer IL2. The N-type charge generation layer may include a dopant of a metal material.

A second charge generation layer for supplying charges to the third stack layer IL3 and supplying electrons to the second stack layer IL2 may be disposed between the second stack layer IL2 and the third stack layer IL3. The second charge generation layer may include an N-type charge generation layer that supplies electrons to the second stack layer IL2 and a P-type charge generation layer that supplies holes to the third stack layer IL3.

The first stack layer IL1 may be disposed on the first electrodes AND and the pixel defining film PDL, and may be disposed on the bottom surface of each trench TRC. Due to the trench TRC, the first stack layer IL1 may be separated between adjacent pixels PX1, PX2, and PX3. The second stack layer IL2 may be disposed on the first stack layer IL1. Due to the trench TRC, the second stack layer IL2 may be separated between adjacent pixels PX1, PX2, and PX3. A cavity ESS or an empty space may be disposed between the first stack layer IL1 and the second stack layer IL2. The third stack layer IL3 may be disposed on the second stack layer IL2. The third stack layer IL3 is not cut off by the trench TRC and may be disposed to cover the second stack layer IL2 in each of the trenches TRC. For example, in the three-tandem structure, each of the plurality of trenches TRC may be a structure for cutting off the first to second stack layers IL1 and IL2, the first charge generation layer, and the second charge generation layer of the display element layer EML between the pixels PX1, PX2, and PX3 adjacent to each other. In addition, in the two-tandem structure, each of the trenches TRC may be a structure for cutting off the charge generation layer disposed between a lower intermediate layer and an upper intermediate layer, and the lower intermediate layer.

In order to stably cut off the first and second stack layers IL1 and IL2 of the display element layer EML between adj acent pixels PX1, PX2, and PX3, the height of each of the plurality of trenches TRC may be greater than the height of the pixel defining film PDL. The height of each of the plurality of trenches TRC refers to the length of each of the plurality of trenches TRC in the third direction DR3. The height of the pixel defining film PDL refers to the length of the pixel defining film PDL in the third direction DR3. In order to cut off the first to third stack layers IL1, IL2, and IL3 of the display element layer EML between the neighboring pixels PX1, PX2, and PX3, another structure may exist instead of the trench TRC. For example, instead of the trench TRC, a reverse tapered partition wall may be disposed on the pixel defining film PDL.

The number of the stack layers IL1, IL2, and IL3 that emit different lights is not limited to that shown in FIG. 6. For example, the light-emitting stack ES may include two intermediate layers. In this case, one of the two intermediate layers may be substantially the same as the first stack layer IL1, and the other may include a second hole transport layer, a second organic light-emitting layer, a third organic light-emitting layer, and a second electron transport layer. In this case, a charge generation layer for supplying electrons to one intermediate layer and supplying charges to the other intermediate layer may be disposed between the two intermediate layers.

In addition, FIG. 6 illustrates that the first to third stack layers IL1, IL2, and IL3 are all disposed in the first emission area EA1, the second emission area EA2, and the third emission area EA3, but the present disclosure is not limited thereto. For example, the first stack layer IL1 may be disposed in the first emission area EA1, and may be omitted from the second emission area EA2 and the third emission area EA3. Furthermore, the second stack layer IL2 may be disposed in the second emission area EA2 and may be omitted from the first emission area EA1 and the third emission area EA3. Further, the third stack layer IL3 may be disposed in the third emission area EA3 and may be omitted from the first emission area EA1 and the second emission area EA2. In this case, first to third color filters CF1, CF2, and CF3 of the optical layer OPL may be omitted.

The second electrode CAT may be disposed on the third stack layer IL3. The second electrode CAT may be disposed on the third stack layer IL3 in each of the plurality of trenches TRC. The second electrode CAT may be formed of a transparent conductive material (TCO) such as ITO or IZO that can transmit light or a semi-transmissive conductive material such as magnesium (Mg), silver (Ag), or an alloy of Mg and Ag. When the second electrode CAT is formed of a semi-transmissive conductive material, the light emission efficiency may be improved in each of the first to third pixels PX1, PX2, and PX3 due to a micro-cavity effect.

The encapsulation layer TFE may be disposed on the display element layer EML. The encapsulation layer TFE may include at least one inorganic film TFE1 and TFE2 to reduce or prevent oxygen or moisture from permeating into the display element layer EML. For example, the encapsulation layer TFE may include the first encapsulation inorganic film TFE1, and the second encapsulation inorganic film TFE2.

The first encapsulation inorganic film TFE1 may be disposed on the second electrode CAT. The first encapsulation inorganic film TFE1 may be formed as a multilayer in which one or more inorganic films selected from silicon nitride (SiNx), silicon oxynitride (SiON), and silicon oxide (SiOx) are alternately stacked. The first encapsulation inorganic film TFE1 may be formed by a chemical vapor deposition (CVD) process.

The second encapsulation inorganic film TFE2 may be disposed on the first encapsulation inorganic film TFE1. The second encapsulation inorganic film TFE2 may be formed of titanium oxide (TiOx) or aluminum oxide (AlOx), but the present disclosure is not limited thereto. The second encapsulation inorganic film TFE2 may be formed by an atomic layer deposition (ALD) process. The thickness of the second encapsulation inorganic film TFE2 may be less than the thickness of the first encapsulation inorganic film TFE1.

An organic film APL may be a layer for increasing the interfacial adhesion between the encapsulation layer TFE and the optical layer OPL. The organic film APL may be an organic film such as acrylic resin, epoxy resin, phenolic resin, polyamide resin, or polyimide resin.

The optical layer OPL may include a color filter layer CFL, a lens layer LSL, a filling layer FIL, a cover layer CVL, a phase retardation layer QWP, and a wire grid polarizer WGP.

The color filter layer CFL may include the plurality of color filters CF1, CF2, and CF3. The plurality of color filters CF1, CF2, and CF3 may include the first to third color filters CF1, CF2, and CF3. The first to third color filters CF1, CF2, and CF3 may be disposed on the adhesive layer ADL.

The first color filter CF1 may overlap the first emission area EA1 (e.g., red light emission area) of the first pixel PX1. The first color filter CF1 may transmit light of the first color, e.g., light of a red wavelength band. The red wavelength band may be about 600 nm to about 750 nm. Thus, the first color filter CF1 may transmit light of the first color among light emitted from the first emission area EA1.

The second color filter CF2 may overlap the second emission area EA2 (e.g., green light emission area) of the second pixel PX2. The second color filter CF2 may transmit light of the second color, e.g., light of a green wavelength band. The green wavelength band may be about 480 nm to about 560 nm. Thus, the second color filter CF2 may transmit light of the second color among light emitted from the second emission area EA2.

The third color filter CF3 may overlap the third emission area EA3 (e.g., blue light emission area) of the third pixel PX3. The third color filter CF3 may transmit light of the third color, e.g., light of a blue wavelength band. The blue wavelength band may be about 370 nm to about 460 nm. Thus, the first color filter CF1 may transmit light of the first color among light emitted from the first emission area EA1.

A planarization layer PLL may be disposed on the color filter layer CFL. The planarization layer PLL may function to planarize the stepped portion at the lower portion. The planarization layer PLL may be an organic film such as acrylic resin, epoxy resin, phenolic resin, polyamide resin, or polyimide resin.

The lens layer LSL may be disposed on the planarization layer PLL. The lens layer LSL may include a plurality of lenses LNS. The plurality of lenses LNS may be disposed on the first color filter CF1, the second color filter CF2, and the third color filter CF3, respectively. Each of the plurality of lenses LNS may be a structure for increasing the proportion of light directed to the front of the display device 10. Each of the plurality of lenses LNS may have a cross-sectional shape that is convex in an upward direction.

The filling layer FIL may be disposed on the lens layer LSL. For example, the filling layer FIL may be disposed on the plurality of lenses LNS. The filling layer FIL may have a predetermined refractive index such that light travels in the third direction DR3 at an interface between the filling layer FIL and the plurality of lenses LNS. Further, the filling layer FIL may be a planarization layer. The filling layer FIL may be an organic film such as acrylic resin, epoxy resin, phenolic resin, polyamide resin, or polyimide resin.

The cover layer CVL may be disposed on the filling layer FIL. The cover layer CVL may be a glass substrate or a polymer resin. The cover layer CVL may be a glass substrate or a polymer resin. When the cover layer CVL is a glass substrate, it may be attached onto the filling layer FIL. In this case, the filling layer FIL may serve to bond the cover layer CVL. When the cover layer CVL is a glass substrate, it may serve as an encapsulation substrate. When the cover layer CVL is a polymer resin, it may be directly applied onto the filling layer FIL.

The phase retardation layer QWP (or retardation plate, or retardation film) may be disposed on the color filter layer CFL. For example, the phase retardation layer QWP may be disposed between the color filter layer CFL and the wire grid polarizer WGP. The phase retardation layer QWP may be a λ/4 plate (quarter-wave plate), but the present disclosure is not limited thereto. The phase retardation layer QWP may be formed, for example, by a coating method.

In an embodiment, the phase retardation layer QWP may include an alignment film ALL, a liquid crystal layer LC disposed on the alignment film ALL, and a capping layer CPL disposed on the liquid crystal layer LC. The alignment film ALL may function to align the liquid crystal layer LC disposed on the alignment film ALL. For example, the alignment film ALL has reactions such as photoisomerization and photocrosslinking that occur anisotropically when irradiated with polarized light, and thus anisotropy may be generated on the polymer surface, which may induce the molecular arrangement of the liquid crystal in one direction. The liquid crystal layer LC may be formed by coating a liquid crystal material containing reactive mesogen (RM) to be aligned on the alignment film ALL and polymerizing them.

The capping layer CPL functions to protect the liquid crystal layer LC. The capping layer CPL may include an inorganic insulating material. For example, the capping layer CPL may include any one material of silicon nitride (SiNx), silicon oxynitride (SiON), and silicon oxide (SiOx). The capping layer CPL may have a predetermined thickness, for example, a thickness of 50 to 1000 nm, to protect the liquid crystal layer LC. In an embodiment, the capping layer CPL may have a thickness of 100 to 500 nm.

The wire grid polarizer WGP may be disposed on the phase retardation layer QWP, may be disposed, for example, between the phase retardation layer QWP and the planarization layer PLL. The wire grid polarizer WGP and the phase retardation layer QWP may constitute a polarization member. For example, the polarization member according to an embodiment may include the phase retardation layer QWP and the wire grid polarizer WGP.

The wire grid polarizer WGP may include a plurality of wire grid patterns GP. As shown in FIG. 5, each wire grid pattern GP may have a rectangular shape extending along the second direction DR2. Further, as shown in FIG. 5, the wire grid patterns GP may be arranged along the first direction DR1. The wire grid patterns GP may be disposed to be spaced apart from each other in the first direction DR1.

The wire grid polarizer WGP may transmit light of a specific polarization direction while reflecting light of another polarization direction to recycle it. This wire grid polarizer WGP is useful as a reflective polarizer because it exhibits higher polarization separation performance than other polarizers. For example, the wire grid polarizer WGP is a device that creates polarization using a conductive wire grid, and may have a structure in which a plurality of wires made of a conductive material are periodically arranged in parallel to each other in a nano size on the phase retardation layer QWP to form the grid patterns GP.

In the wire grid polarizer WGP including the plurality of wire grid patterns GP, if the period of the wire grid pattern GP is less than the wavelength of the incident light, diffraction of the incident light does not occur. Thus, the wire grid polarizer WGP may transmit, among the incident light, a component having a vibration direction orthogonal to the conductive wire grid pattern GP, such as transverse magnetic (TM) polarization (e.g., a P wave), while reflecting a component having a vibration direction parallel to the wire grid pattern GP, such as transverse electric (TE) polarization (e.g., a S wave). In other words, when the arrangement period of the wire grid pattern GP is shorter than the wavelength of the electromagnetic wave incident on the wire grid polarizer WGP, the wire grid polarizer WGP may reflect a polarization component (e.g., S wave) parallel to the wire grid pattern GP, while transmitting a polarization component (e.g., P wave) orthogonal to the wire grid pattern GP. Since the wire grid polarizer WGP uses the wire grid pattern GP made of metal, light reflection efficiency thereof is very high. Thus, as the reflected light can be re-reflected, the light can be recycled to make all lights into one polarized light.

The wire grid patterns GP may be disposed to be spaced apart from each other by a first pitch P1 in the first direction DR1. The first pitch P1 may be a distance between the centers of the wire grid patterns GP adjacent to each other. The first pitch P1 of the wire grid pattern GP may be 50 to 150 nm. In an embodiment, the first pitch P1 of the wire grid pattern GP may be 50 to 100 nm. The first pitch P1 of the wire grid patterns GP may be the same in all the wire grid patterns GP, or some may be different from each other.

The wire grid patterns GP may be disposed to be spaced apart from each other in the first direction DR1 with a separation distance equal to a second pitch P2. The second pitch P2 may be a distance between side edges of the wire grid patterns GP adjacent to each other. The second pitch P2 of the wire grid pattern GP may be 40 to 100 nm. In an embodiment, the second pitch P2 of the wire grid pattern GP may be 40 to 50 nm. The second pitch P2 of the wire grid pattern GP may be the same in all the wire grid patterns GP, or some may be different from each other.

The wire grid pattern GP may have a predetermined thickness in consideration of process properties, reflection characteristics, or the like. A thickness TK1 of the wire grid pattern GP may be 10 to 1000 nm. In an embodiment, the thickness TK1 of the wire grid pattern GP may be 100 to 300 nm. The thickness TK1 of the wire grid patterns GP may be the same in all the wire grid patterns GP, or some may be different from each other.

The wire grid pattern GP may include a grid pattern GPL and an insulating pattern IPL.

The grid pattern GPL may form the lower layer portion of the wire grid pattern GP and may substantially perform the function of the wire grid pattern GP. The grid pattern GPL may be disposed between the capping layer CPL and the insulating pattern IPL, and may be disposed directly on the capping layer CPL. The grid pattern GPL may include a material with high reflectivity to perform the light reflection function described above. For example, the grid pattern GPL may include one selected from the group consisting of aluminum (Al), chromium (Cr), silver (Ag), copper (Cu), nickel (Ni), titanium (Ti), cobalt (Co), and molybdenum (Mo), or an alloy thereof. A thickness TK2 of the grid pattern GPL may be 10 to 1000 nm.

The insulating pattern IPL may form the upper layer portion of the wire grid pattern GP, and may serve as a mask during a patterning process of the grid pattern GPL. The insulating pattern IPL may be disposed between the planarization layer PLL and the grid pattern GPL. The insulating pattern IPL may be disposed directly on the grid pattern GPL.

The insulating pattern IPL may include an inorganic insulating material. For example, the insulating pattern IPL may include silicon oxynitride, silicon oxide or silicon nitride. The insulating pattern IPL may have a thickness TK3 ranging from 1 nm to 1000 nm. In an embodiment, the thickness TK3 of the insulating pattern IPL may be set to 10 nm to 100 nm in consideration of adhesion, reliability, and transmittance. Additionally, the thickness TK3 of the insulating pattern IPL may be less than the thickness TK2 of the grid pattern GPL. Since the insulating pattern IPL acts as a mask during the patterning process of the grid pattern GPL, the width of the insulating pattern IPL may be substantially the same as the width of the grid pattern GPL.

The wire grid pattern GP may include doped ions. For example, the grid pattern GPL and the insulating pattern IPL may include ions. The ions may penetrate into the wire grid pattern GP in a doping process to be described later. The ions may include, for example, boron.

The concentration of the ions may differ within the wire grid pattern GP. For example, the concentration of the ions included in the insulating pattern IPL may be different from the concentration of the ions included in the grid pattern GPL. Since the ion doping process is performed in an upper portion of the substrate, the concentration of the ions in the insulating pattern IPL forming the upper layer portion of the wire grid pattern GP may be greater than the concentration of the ions in the grid pattern GPL forming the lower layer portion of the wire grid pattern GP.

In an embodiment, the concentration of the ions in the wire grid pattern GP may gradually increase from the top to the bottom of the wire grid pattern GP. For example, the concentration of the ions in the insulating pattern IPL may gradually increase from the top surface to the bottom surface of the insulating pattern IPL, and the concentration of the ions in the grid pattern GPL may gradually increase from the top surface to the bottom surface of the grid pattern GPL. In an embodiment, the concentration of the ions in a lower portion of the insulating pattern IPL may be greater than the concentration of the ions in an upper portion of the grid pattern GPL.

In an embodiment, the amount of the ions in the insulating pattern IPL forming the upper layer portion of the wire grid pattern GP may be equal to the amount of the ions in the grid pattern GPL forming the lower layer portion of the wire grid pattern GP. Since the wire grid pattern GP is very thin, ranging from several to several hundreds of nanometers in thickness, the amount of the ions in the grid pattern GPL and the amount of the ions in the insulating pattern IPL may be substantially the same with no difference.

The wire grid polarizer WGP may include an air layer AIL. The air layer AIL may be disposed between the wire grid patterns GP. Specifically, the air layer AIL may be disposed in an area defined by the capping layer CPL, the wire grid patterns GP, and the planarization layer PLL. The air layer AIL may be disposed between the wire grid patterns GP and extend in the second direction DR2 in parallel with the wire grid patterns GP. The air layers AIL may be disposed to be spaced apart from each other in the first direction DR1 with the wire grid pattern GP interposed therebetween. The air layer AIL may act as a path through which light emitted from the internal light-emitting stack ES is transmitted.

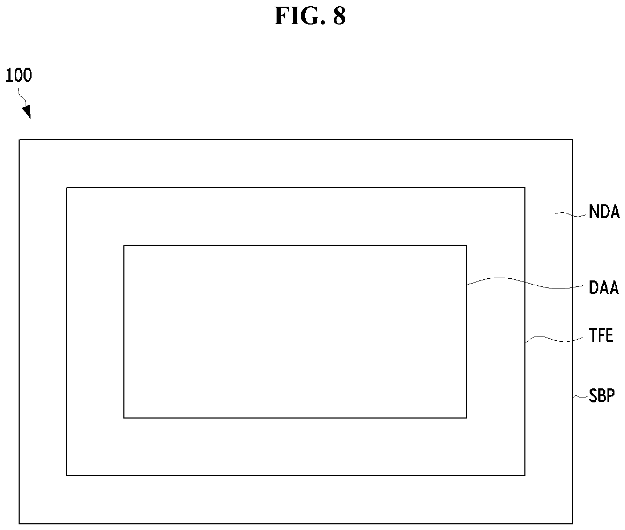

FIG. 8 is a plan view schematically illustrating a display device 100 according to an embodiment.

Referring to FIG. 8 in conjunction with FIG. 6, the encapsulation layer TFE may be disposed on the display area DAA and the non-display area NDA. The optical layer OPL may be mostly disposed on the display area DAA, and may not be disposed on a portion of the non-display area NDA. The wire grid polarizer WGP included in the optical layer OPL may also be disposed on the display area DAA, and may not be disposed on a portion of the non-display area NDA, for example, at the edge of the non-display area NDA.

The ion doping process to be described below may be performed when forming the wire grid polarizer WGP. Since the ion doping process is performed entirely without using a separate mask, the ions may be doped not only in the display area DAA where the wire grid polarizer WGP is formed, but also in the non-display area NDA. Therefore, the encapsulation layer TFE may have a region containing the ions and a region not containing the ions. Here, the encapsulation layer TFE may refer to at least one of the first encapsulation inorganic film TFE1 or the second encapsulation inorganic film TFE2.

In an embodiment, a first region of the encapsulation layer TFE overlapping the display area DAA may not contain the ions, whereas a second region thereof overlapping the non-display area NDA may contain the ions. Here, the second region of the encapsulation layer TFE containing the ions may be a region that does not overlap the optical layer OPL, and the first region of the encapsulation layer TFE not containing the ions may be a region that overlaps the optical layer OPL. In other words, the second region of the encapsulation layer TFE containing the ions may be a region that does not overlap the wire grid polarizer WGP, and the first region of the encapsulation layer TFE not containing the ions may be a region that overlaps the wire grid polarizer WGP.

In an embodiment, the ions may be included in the entire encapsulation layer TFE. In this case, the concentration of the ions in the first region of the encapsulation layer TFE overlapping the display area DAA may be less than the concentration of the ions in the second region overlapping the non-display area NDA. In the first region of the encapsulation layer TFE overlapping the display area DAA, since the organic film APL, the color filter layer CFL, and the phase retardation layer QWP are disposed between the encapsulation layer TFE and the wire grid polarizer WGP, the concentration of the ions penetrating into the encapsulation layer TFE may be low. On the other hand, in the second region of the encapsulation layer TFE overlapping the non-display area NDA, since no other layers are disposed on top of the encapsulation layer TFE, the concentration of the ions may be high.

Whether or not the ion doping process to be described below has been performed may be confirmed by checking whether or not the wire grid polarizer WGP includes ions and/or whether or not the encapsulation layer TFE of the non-display area NDA includes ions.

Hereinafter, a method of manufacturing the display device according to the above-described embodiment will be explained.

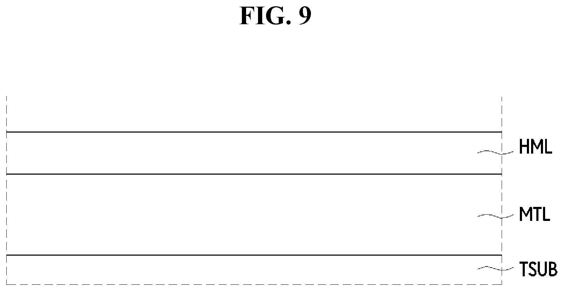

FIGS. 9 to 18 are diagrams showing a method of manufacturing a display device according to an embodiment. Hereinafter, in the various drawings, description of a manufacturing process for the semiconductor backplane SBP, the light-emitting element backplane EBP, the display element layer EML, the encapsulation layer TFE, the color filter layer CFL, and the phase retardation layer QWP will be omitted, focusing on the description of a manufacturing process for the wire grid polarizer WGP.

Referring to FIG. 9, a metal material layer MTL and an insulating material layer HML are formed on a target substrate TSUB.

The target substrate TSUB may be a substrate on which the semiconductor backplane SBP, the light-emitting element backplane EBP, the display element layer EML, the encapsulation layer TFE, the color filter layer CFL, and the phase retardation layer QWP are formed, as shown in FIG. 6. The top surface of the target substrate TSUB, for example, the surface on which the metal material layer MTL is formed may be the phase retardation layer QWP.

The metal material layer MTL is for forming the grid pattern GPL illustrated in FIG. 7, and may contain a metal material. For example, the metal material layer MTL may include one selected from the group consisting of aluminum (Al), chromium (Cr), silver (Ag), copper (Cu), nickel (Ni), titanium (Ti), cobalt (Co), and molybdenum (Mo), or an alloy thereof. The metal material layer MTL may be formed using a general metal material lamination method, for example, sputtering, chemical vapor deposition (CVD), or evaporation.

The insulating material layer HML is a hard mask for etching the grid pattern GPL illustrated in FIG. 7, and may contain an inorganic insulating material. For example, the insulating material layer HML may contain silicon oxynitride (SiON), silicon oxide (SiOx), or silicon nitride (SiNx). The insulating material layer HML may be formed using chemical vapor deposition (CVD), or the like.

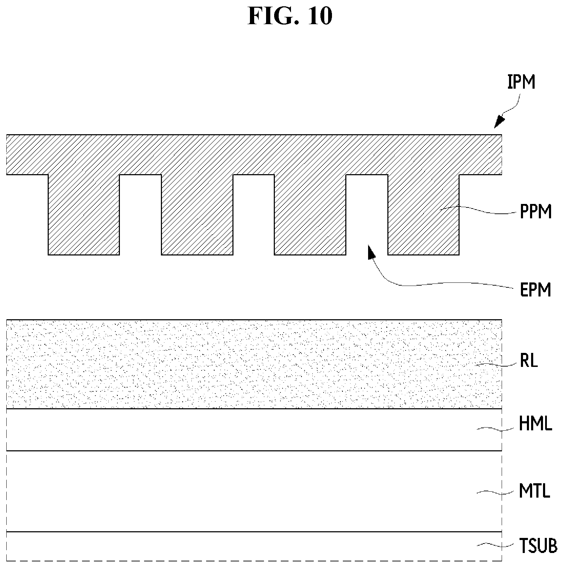

Next, referring to FIG. 10, a resin layer RL is formed on the insulating material layer HML. The resin layer RL may be formed through a solution process such as inkjet printing, spin coating, slit coating, or gravure coating. Among these, the inkjet printing may be suitable as a method for forming the resin layer RL because it enables application of a required amount of resin to a required portion. When a resin material is applied on the insulating material layer HML by the inkjet printing, the resin may spread on the insulating material layer HML to form the resin layer RL with a uniform thickness.

Then, a mold IPM is aligned on the resin layer RL. The mold IPM may serve as a stamp capable of forming a specific shape in the resin layer RL by pressing the resin layer RL through an imprinting process. For example, a soft mold with flexibility may be used as the mold IPM.

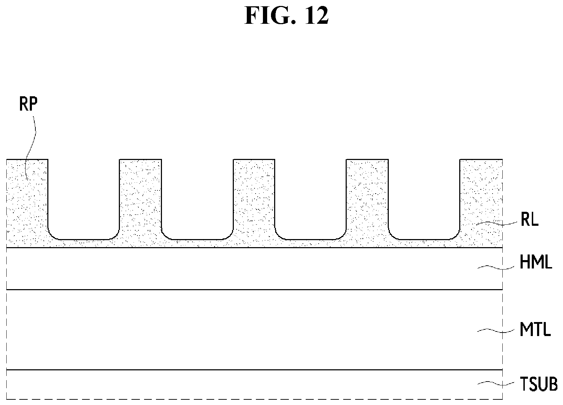

The mold IPM may include protrusions PPM and recesses EPM. The protrusion PPM may form a recess of the resin layer RL, and the recess EPM may form a protrusion of the resin layer RL. The protrusions PPM and the recesses EPM of the mold IPM may have predetermined widths and spacings, so that the resin layer RL including resin patterns RP (see FIG. 12) having predetermined width and spacing may be formed in the imprinting process to be described below.

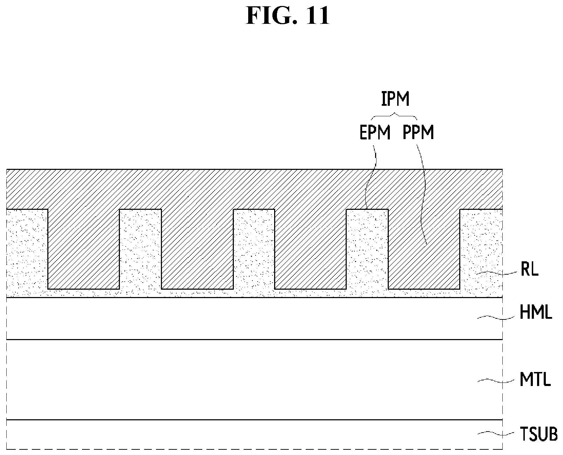

Subsequently, referring to FIGS. 11 and 12, the resin layer RL may be pressed using the mold IPM. With the protrusions PPM of the mold IPM aligned toward the resin layer RL, the mold IPM may be pressed against the resin layer RL. In the process of pressing the mold IPM, the mold IPM may be pressed vertically, or pressed sequentially from one side to the other side thereof using a roll device.

When the mold IPM presses the resin layer RL, the resin of the resin layer RL may be filled into the recesses EPM of the mold IPM, and a surplus of the resin may spread to the surrounding area, so that the recesses EPM of the mold IPM may be entirely filled with the resin.

Thereafter, when the mold IPM is separated from the resin layer RL, the resin patterns RP may be transferred to the resin layer RL, as shown in FIG. 12. The resin layer RL may include not only the resin patterns RP but also a layer where a portion of the resin layer RL covers the insulating material layer HML between the resin patterns RP.

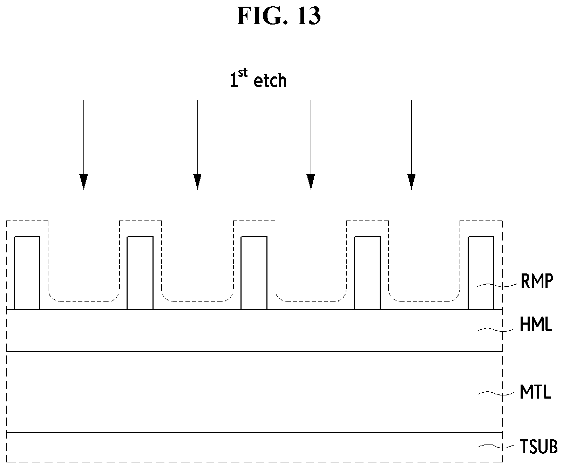

Next, referring to FIG. 13, the first etching (1^{st} etch) is performed on the resin layer RL to form a resin mask pattern RMP.

To elaborate, the resin layer RL provided with the resin patterns RP is etched to reduce the size of the resin patterns RP and remove a portion of the remaining resin layer RL. The first etching (1^{st} etch) may be implemented by a dry etching process. The dry etching process may utilize, for example, plasma etching. The plasma etching may utilize fluorine (F), but is not limited thereto.

In the first etching (1^{st} etch) process, the size of the resin pattern RP, such as the height and the width thereof, may be reduced, thereby forming the resin mask pattern RMP of a smaller size. In addition, the remaining resin layer RL, for example, the remaining resin other than the resin patterns RP, may be removed, thereby completely exposing the underlying insulating material layer HML.

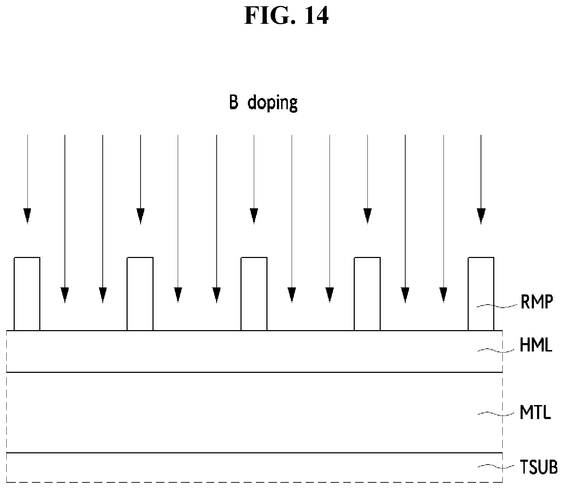

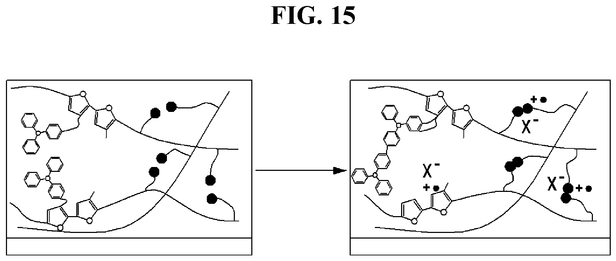

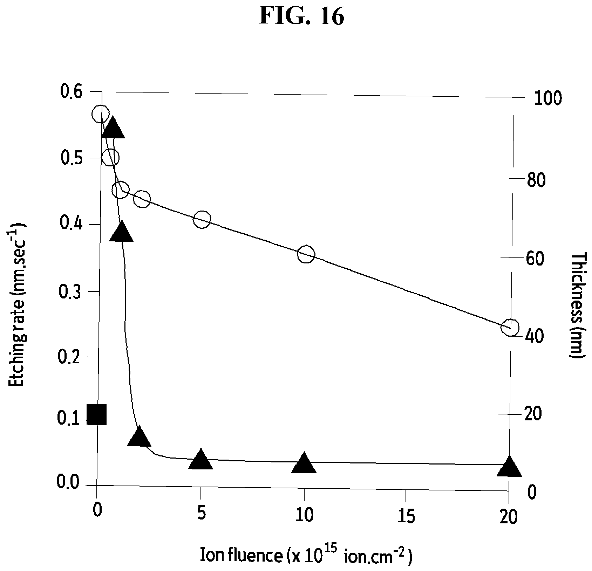

Next, referring to FIGS. 14 to 16, an ion doping process is performed on the target substrate TSUB. FIG. 14 shows the ion doping process, FIG. 15 is a schematic diagram showing a state in which compounds of resin are cross-linked by doped ions (X⁻) when the ions are doped into the resin, and FIG. 16 is a graph showing an etching rate and an etching thickness according to the amount of the ion doping.

The ion doping process may be a process of doping ions into a resin pattern RMP. The ions used in the ion doping process may include boron (B) ions. The ions may be doped in a dose ranging from 5E15/cm² to 1E16/cm². For example, the dose of the boron ions may be in the range of 5E16/cm² to 1E16/cm². If the dose of the boron ions is equal to or more than 5E16/cm², crosslinking of the resin may be incurred within the resin pattern RMP, thereby making the resin pattern RMP robust to etching, and if the dose of the boron ions is equal to or less than 1E16/cm², an increase in the time of the ion doping process may be prevented. In addition, the acceleration voltage of the ion doping may be 10 KeV to 20 KeV.

As shown in FIG. 15, when resin, such as polythiophene, is doped with ions (X⁻), chain scission occurs, so bonds such as carbon-carbon, carbon-nitrogen, and carbon-oxygen bonds in an organic compound chain may be broken, and the broken carbon may chemically bond with another broken carbon or the end of the chain. Accordingly, due to an increase in the molecular force of the organic compound, the strength of the resin may be enhanced, and changes in physical properties, such as an increase in selectivity by etching, may occur.

As can be seen from FIG. 16, both the etching rate and the etched thickness of the ion-doped resin decrease with an increase of the amount of the ion doping.

In the present embodiment, by doping the ions into the resin mask pattern RMP, the resin mask pattern RMP may be made robust to the etching process. That is, the resin mask pattern RMP may become robust to perform its role as a mask well, and a process margin may be secured due to an increase in etching selectivity.

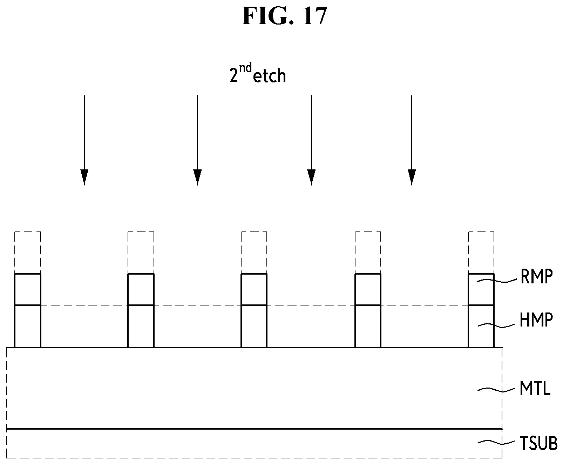

Next, referring to FIG. 17, the second etching (2^{nd} etch) is performed on the insulating material layer HML (e.g., see FIG. 14) to form a hard mask pattern HMP (see FIG. 17).

Specifically, by using the resin mask patterns RMP as a mask, the insulating material layer HML that is not masked by the resin mask patterns RMP is etched. The second etching (2^{nd} etch) may be implemented by a dry etching process. The dry etching process may utilize, for example, plasma etching. The plasma etching may utilize fluorine (F), but is not limited thereto.

In the second etching (2^{nd} etch) process, the resin mask pattern RMP and the insulating material layer HML may be etched simultaneously. In the present embodiment, since the resin mask pattern RMP is doped with the ions to reduce selectivity by etching, it may be etched in the etching process to the extent that its thickness is somewhat reduced. That is, since the resin mask pattern RMP is not completely removed by the etching process, it may perform well the role of a mask for forming the hard mask pattern HMP.

All regions of the insulating material layer HML that are not masked by the resin mask patterns RMP may be removed, so that the hard mask pattern HMP may be formed. The hard mask pattern HMP is an area overlapping the resin mask pattern RMP, and may be formed to have substantially the same width as the resin mask pattern RMP. As the resin mask pattern RMP is formed, a portion of the underlying metal material layer MTL may be exposed.

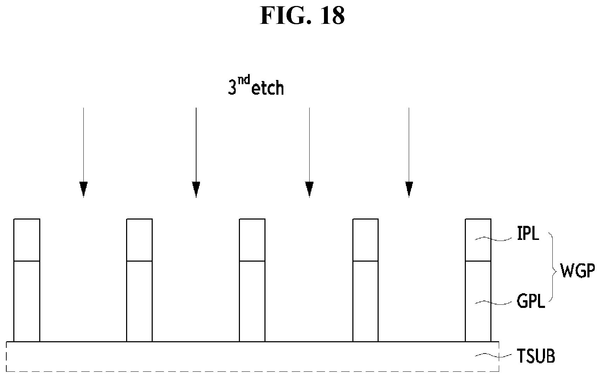

Next, referring to FIG. 18, the third etching (3^{rd} etch) is performed on the metal material layer MTL to form the grid pattern GPL.

To be specific, the metal material layer MTL is etched using the resin mask pattern RMP and the hard mask pattern HMP as a mask. The third etching (3^{rd} etch) may be implemented by a dry etching process. The dry etching process may utilize, for example, plasma etching. The plasma etching may utilize chlorine (Cl), but is not limited thereto.

In the third etching (3^{rd} etch) process, the resin mask pattern RMP, the hard mask pattern HMP, and the metal material layer MTL may be etched simultaneously. For example, in the third etching (3^{rd} etch) process, the resin mask pattern RMP is completely etched and removed, and the hard mask pattern HMP may be partially etched to the extent that its thickness is somewhat reduced. That is, since the resin mask pattern RMP is used as a mask in the third etching (3^{rd} etch) process as well, the hard mask pattern HMP may remain, performing well the role of a mask for the metal material layer MTL.

All regions of the metal material layer MTL that are not masked by the resin mask patterns RMP and the hard mask patterns HMP may be removed, so that the grid pattern GPL may be formed. The remaining hard mask pattern HMP (FIG. 17) may be formed into the insulating pattern IPL (FIG. 18) on the grid pattern GPL. The grid pattern GPL is an area overlapping the insulating pattern IPL, and may be formed to have substantially the same width as the insulating pattern IPL. In addition, the thickness of the grid pattern GPL may be greater than the thickness of the insulating pattern IPL. As the grid pattern GPL and the insulating pattern IPL are formed, the wire grid polarizer WGP may be obtained.

Thereafter, the planarization layer PLL, the lens layer LSL, the filling layer FIL, and the cover layer CVL illustrated in FIG. 6 may be sequentially formed to manufacture a display device.

According to the manufacturing method of the display device described above, by doping ions into the resin mask pattern RMP to increase selectivity by etching, the resin mask pattern RMP may be enabled to perform the role of a mask even in multiple etching processes. Accordingly, by forming the grid pattern GPL of the wire grid polarizer WGP to have uniform pitch and width, the transmittance and the polarization degree of the wire grid polarizer WGP may be improved.

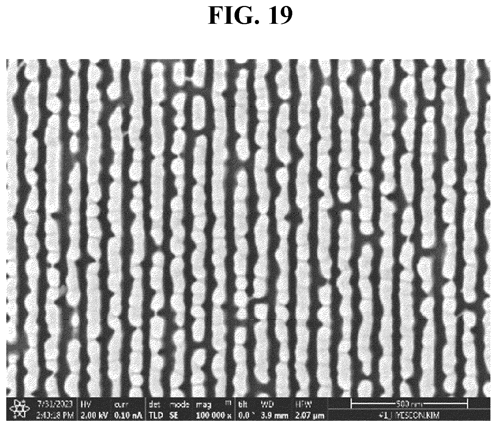

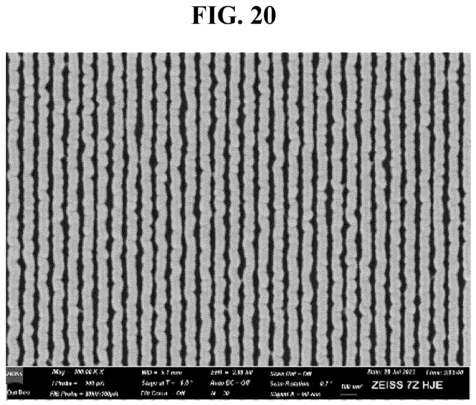

FIG. 19 is a planar image of a wire grid polarizer manufactured according to a comparative example. FIG. 20 is a planar image of a wire grid polarizer according to an embodiment.

FIGS. 19 and 20 illustrate the planar images of the wire grid polarizers manufactured with and without a process of doping boron into the resin mask pattern RMP in the manufacture of the wire grid polarizers. In the comparative example of FIG. 19, boron doping was not performed on the resin mask pattern RMP, and in the embodiment of FIG. 20, boron doping was performed on the resin mask pattern RMP to manufacture the wire grid polarizer.

As illustrated in FIG. 19, the wire grid polarizer according to the comparative example was found to have a discontinuous grid pattern with an irregular width and a pitch of approximately 33.9 nm. On the other hand, the wire grid polarizer according to the embodiment was found to have a grid pattern formed continuously without interruption and having a relatively uniform width, as illustrated in FIG. 20. In addition, the pitch of the grid pattern was measured to be approximately 41.1 nm, which indicates that the grid pattern was formed more precisely.

In view of this result, it was confirmed that the grid pattern GPL of the wire grid polarizer WGP with uniform pitch and width may be formed by performing the ion doping process on the resin mask pattern RMP.

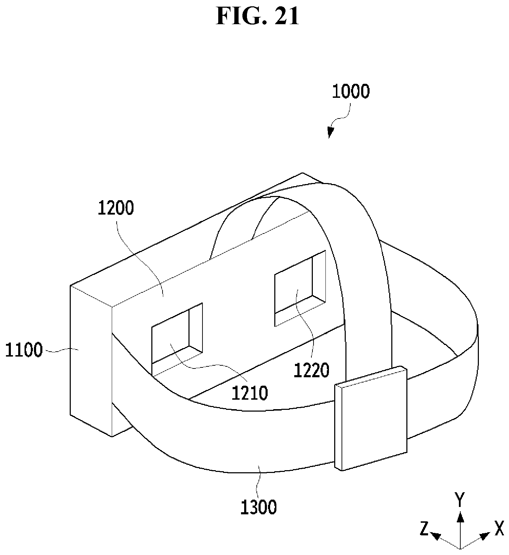

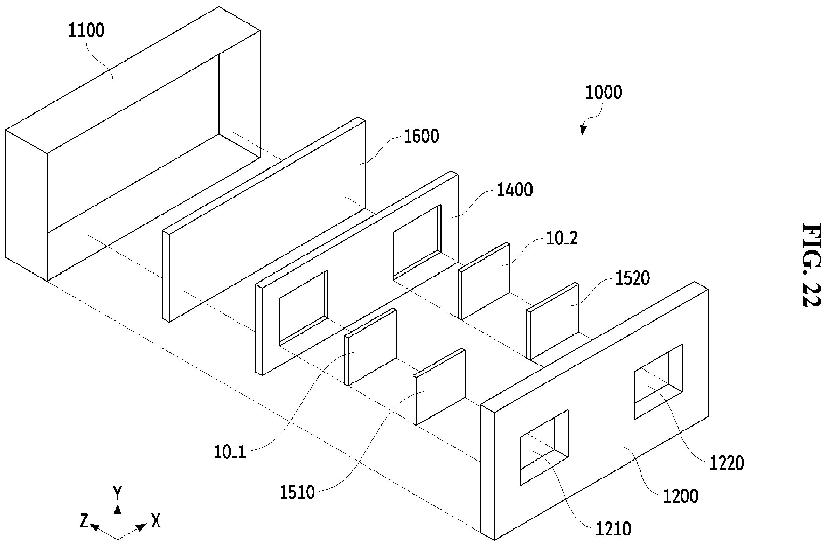

FIG. 21 is a perspective view illustrating a head mounted display 1000 according to an embodiment. FIG. 22 is an exploded perspective view illustrating an example of the head mounted display 1000 of FIG. 21.

Referring to FIGS. 21 and 22, the head mounted display 1000 according to an embodiment includes a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_1 provides an image to the user's left eye, and the second display device 10_2 provides an image to the user's right eye. Since each of the first display device 10_1 and the second display device 10_2 is substantially the same as the display device 10 described in conjunction with FIG. 1, description of the first display device 10_1 and the second display device 10_2 will be omitted.

The first optical member 1510 may be disposed between the first display device 10_1 and the first eyepiece 1210. The second optical member 1520 may be disposed between the second display device 10_2 and the second eyepiece 1220. Each of the first optical member 1510 and the second optical member 1520 may include at least one convex lens.

The middle frame 1400 may be disposed between the first display device 10_1 and the control circuit board 1600 and between the second display device 10_2 and the control circuit board 1600. The middle frame 1400 serves to support and fix the first display device 10_1, the second display device 10_2, and the control circuit board 1600.

The control circuit board 1600 may be disposed between the middle frame 1400 and the display device housing 1100. The control circuit board 1600 may be connected to the first display device 10_1 and the second display device 10_2 through a connector. The control circuit board 1600 may convert an image source inputted from the outside into the digital video data DATA, and transmit the digital video data DATA to the first display device 10_1 and the second display device 10_2 through the connector.

The control circuit board 1600 may transmit the digital video data DATA corresponding to a left-eye image optimized for the user's left eye to the first display device 10_1, and may transmit the digital video data DATA corresponding to a right-eye image optimized for the user's right eye to the second display device 10_2. In an embodiment, the control circuit board 1600 may transmit the same digital video data DATA to the first display device 10_1 and the second display device 10_2.

The display device housing 1100 serves to accommodate the first display device 10_1, the second display device 10_2, the middle frame 1400, the first optical member 1510, the second optical member 1520, and the control circuit board 1600. The housing cover 1200 is disposed to cover one open surface of the display device housing 1100. The housing cover 1200 may include the first eyepiece 1210 at which the user's left eye is located and the second eyepiece 1220 at which the user's right eye is located. FIGS. 21 and 22 illustrate that the first eyepiece 1210 and the second eyepiece 1220 are disposed separately, but the present disclosure is not limited thereto. The first eyepiece 1210 and the second eyepiece 1220 may be combined into one.

The first eyepiece 1210 may be aligned with the first display device 10_1 and the first optical member 1510, and the second eyepiece 1220 may be aligned with the second display device 10_2 and the second optical member 1520. Therefore, the user may view, through the first eyepiece 1210, the image of the first display device 10_1 magnified as a virtual image by the first optical member 1510, and may view, through the second eyepiece 1220, the image of the second display device 10_2 magnified as a virtual image by the second optical member 1520.

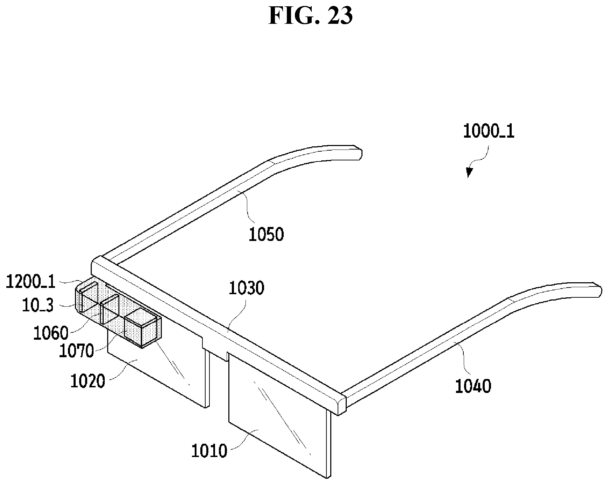

The head mounted band 1300 serves to secure the display device housing 1100 to the user's head such that the first eyepiece 1210 and the second eyepiece 1220 of the housing cover 1200 remain located on the user's left and right eyes, respectively. When the display device housing 1200 is implemented to be lightweight and compact, the head mounted display 1000 may be provided with, as shown in FIG. 23, an eyeglass frame, which will be described later, instead of the head mounted band 1300.

In addition, the head mounted display 1000 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 23 is a perspective view illustrating a head mounted display 1000_1 according to an embodiment.

Referring to FIG. 23, a head mounted display 1000_1 according to an embodiment may be an eyeglasses-type display device in which a display device housing 1200_1 is implemented in a lightweight and compact manner. The head mounted display 1000_1 according to an embodiment may include a display device 10_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 10_3, the optical member 1060, and the optical path changing member 1070. The image displayed on the display device 10_3 may be magnified by the optical member 1060, and may be provided to the user's right eye through the right eye lens 1020 after the optical path thereof is changed by the optical path changing member 1070. As a result, the user may view an augmented reality image, through the right eye, in which a virtual image displayed on the display device 10_3 and a real image seen through the right eye lens 1020 are combined.

FIG. 23 illustrates that the display device housing 1200_1 is disposed at the right end of the support frame 1030, but the present disclosure is not limited thereto. For example, the display device housing 1200_1 may be disposed at the left end of the support frame 1030, and in this case, the image of the display device 10_3 may be provided to the user's left eye. In an embodiment, the display device housing 1200_1 may be disposed at both the left and right ends of the support frame 1030, and in this case, the user may view the image displayed on the display device 10_3 through both the left and right eyes.

In concluding the detailed description, those skilled in the art will appreciate that many variations and modifications can be made to the embodiments without substantially departing from the principles of the inventive concept. Therefore, the disclosed embodiments of the inventive concept are used in a generic and descriptive sense only and not for purposes of limitation.

## Claims

1. A display device (10, 10_3) comprising:
a substrate (SSUB);
a display element layer (EML) disposed on the substrate, and comprising a first electrode, a light-emitting layer, and a second electrode;
a phase retardation layer (QWP) disposed on the display element layer; and
a wire grid polarizer (WGP) disposed on the phase retardation layer, and comprising a wire grid pattern in which an insulating pattern and a grid pattern are stacked,
wherein the insulating pattern (IPL) and the grid pattern (GPL) contain doped ions.

2. The display device (10, 10_3) of claim 1, wherein the doped ions contain boron.

3. The display device (10, 10_3) of claim 1 or 2, wherein a concentration of the ions contained in the insulating pattern (IPL) is different from a concentration of the ions contained in the grid pattern (GPL).

4. The display device (10, 10_3) of any of the preceding claims, wherein a concentration of the ions contained in the insulating pattern (IPL) is greater than a concentration of the ions contained in the grid pattern (GPL).

5. The display device (10, 10_3) of any of the preceding claims, wherein a concentration of the ions contained in the insulating pattern (IPL) gradually increases from a top surface to a bottom surface of the insulating pattern.

6. The display device (10, 10_3) of any of the preceding claims, wherein a concentration of the ions contained in the grid pattern (GPL) gradually increases from a top surface to a bottom surface of the grid pattern.

7. The display device (10, 10_3) of claim 1 or 2, wherein a concentration of the ions contained in the insulating pattern (IPL) is equal to a concentration of the ions contained in the grid pattern (GPL).

8. The display device (10, 10_3) of any of the preceding claims, wherein the insulating pattern is disposed on the grid pattern (GPL), and a thickness of the insulating pattern (IPL) is less than a thickness of the grid pattern.

9. The display device (10, 10_3) of any of the preceding claims, wherein a width of the insulating pattern (IPL) is equal to a width of the grid pattern (GPL).

10. The display device (10, 10_3) of any of the preceding claims, further comprising:
a planarization layer (PLL) disposed on the wire grid polarizer; and
a capping layer (CPL) disposed under the wire grid polarizer,
wherein the wire grid polarizer comprises an air layer disposed in an area defined by the capping layer, the wire grid pattern (GPL), and the planarization layer.
